(19) Europäisches Patentamt
European Patent Office
Office européen des brevets

(11) EP 0 911 875 A2

# (12) EUROPEAN PATENT APPLICATION

(43) Date of publication:
**28.04.1999 Bulletin 1999/17**

(51) Int Cl.6: **H01L 21/768**, C23C 18/12, C01B 33/16

(21) Application number: **98308630.7**

(22) Date of filing: **22.10.1998**

(84) Designated Contracting States:
**AT BE CH CY DE DK ES FI FR GB GR IE IT LI LU MC NL PT SE**
Designated Extension States:
**AL LT LV MK RO SI**

(30) Priority: **23.10.1997 US 63226 P**

(71) Applicant: **TEXAS INSTRUMENTS INCORPORATED**
**Dallas Texas 75265 (US)**

(72) Inventors:
- **Jin, Changming**
  **Dallas, Texas 75243 (US)**
- **List, Richard Scott**
  **Dallas,Texas 75229 (US)**
- **Luttmer, Joseph D.**
  **Richardson, Texas 75082 (US)**

(74) Representative: **Darby, David Thomas et al**
**Abel & Imray,**
**20 Red Lion Street**
**London WC1R 4PQ (GB)**

## (54) Integrated circuit dielectric and method of fabrication thereof

(57) A xerogel aging system includes an aging chamber (190) with inlets and outlet and flows a gel catalyst in gas phase over a xerogel precursor film on a semiconductor wafer. Preferred embodiments use an ammonia and water vapor gas mixture catalyst.

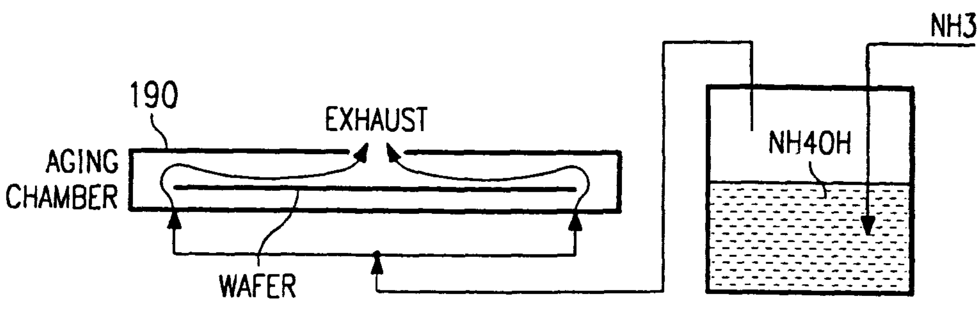


*FIG. 1h*

EP 0 911 875 A2

## Description

### BACKGROUND OF THE INVENTION

The invention generally relates to semiconductor devices, and, more particularly, to dielectric structures and fabrication methods for such structures.

The performance of high density integrated circuits is dominated by metal interconnect level RC time delays due to the resistivity of the metal lines and the capacitive coupling between adjacent lines. The capacitive coupling can be reduced by decreasing the relative permittivity (dielectric constant, k) of the dielectric (insulator) between adjacent lines.

Various dielectric materials have been suggested for use in silicon integrated circuits; namely, silicon dioxide (k about 4.0), fluorinated silicon dioxide (k about 3.0-4.0), organic materials such as polyimide, parylene, amorphous teflon (k about 1.9 -3.9), and porous dielectrics such as silicon dioxide xerogels (k dependent upon pore size and typically 1.3-3.0). The porosity can be up to 99% by volume. See Smith et al, Preparation of Low-Density Xerogel at Ambient Pressure for Low k Dielectrics, 381 Mat.Res.Soc.Symp.Proc. 261 (1995).

Thin film silica xerogels for integrated circuit dielectric use can be fabricated by the generic steps of (1) precursor preparation, (2) spin coating, (3) aging, (4) solvent exchange, and (5) drying. The acid-base sol-gel reactions could be as follows:

Hydrolyze an alkoxide in a solvent:

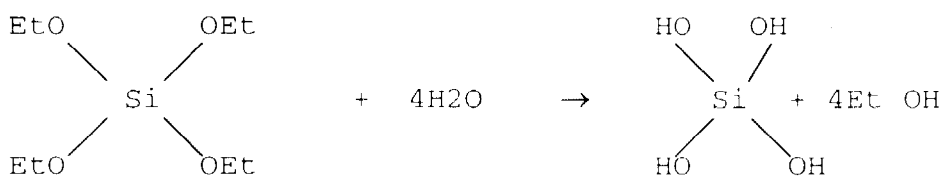

The solvent could be ethanol (EtOH).
The solvent could be ethanol (EtOH).

Then condense (gel) the hydrolyzed alkoxides:

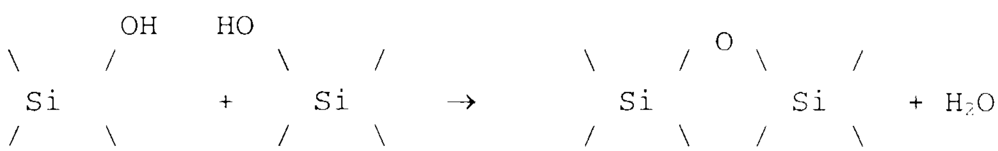

The condensation would be controlled so that spin coating occurs after partial condensation to a convenient viscosity.

The solvent exchange replaces the original solvent residing within the pores of the gel by low-surface-tension solvent to reduce the capillary pressure during drying and minimizing the collapse of the pores. United States Patent No. 5,561,318 discloses variations of the process.

However, silica xerogels have not yet become manufacturable.

### SUMMARY OF THE INVENTION

The present invention provides silica xerogel dielectric fabrication with gel aging in a flowing catalyst ambient in an aging chamber. Preferred embodiment ambients include saturated ammonium hydroxide.

This has the advantages of manufacturable interlevel dielectrics incorporating xerogel to lower dielectric constant.

### BRIEF DESCRIPTION OF THE DRAWINGS

The present invention will now be further described, by way of example, with reference to the accompanying drawings in which:

Figures 1a-k are cross sectional elevation views of an integrated circuit structure fabricated according to the method disclosed herein;
And an apparatus for performing said method;
Figures 2a-b illustrate in cross sectional elevation views an alternative integrated circuit fabricated according to the method disclosed herein;
Figures 3a-f show in cross sectional elevation views a further alternative integrated circuit fabricated accordiing to the method disclosed herein;
Figures 4a-c are cross sectional elevation views of another alternative integrated circuit fabricated according to the method disclosed herein.
Figure 5 shows open pore filling adhesion;
Figure 6 illustrates hard shell;
Figures 7a-b show in cross sectional elevation views of steps of a further preferred method of fabrication; and.
Figures 8a-e illustrates in cross sectional and plan views preferred layout structures for an integrated circuit structure fabricated according to the method disclosed herein.

DESCRIPTION OF THE PREFERRED EMBODIMENTS

The preferred embodiments facilitate incorporation of xerogel as a major component of interlevel dielectrics for integrated circuits by providing gel aging chambers with continuously flowing catalyst (such as ammonia and water vapor mixtures) plus automated spin rinse solvent exchange and hydrophobic surface treatment. This permits fully automated and integrated xerogel formation: a precursor spin coater, an aging chamber, a spin rinser, and a drying chamber may all be structured together with automatic wafer transport between.

Figures 1a-g illustrate in cross sectional elevation views the steps of preferred embodiment fabrication methods for integrated circuits (e.g., CMOS or BiCMOS) as follows.

(1) Start with a silicon wafer (or silicon on insulator wafer) with shallow trench isolation and twin wells for CMOS devices (optionally, plus memory cell array wells and bipolar device buried layers). Perform threshold adjustment implants (which may differ for cell transistors and various peripheral transistors), and form gate dielectric. Deposit tungsten silicide coated polysilicon gate material and a silicon dioxide layer, then pattern the layers to form oxide-topped gates plus gate level interconnects. The gate material could also provide a polysilicon emitter for bipolar devices which would also require a prior base implant. See Figure 1a which shows silicon substrate 102 with shallow trench isolation oxide 104 plus gates 110 and gate level interconnect 112. Gates 110 may be 200-300 nm high and 130-250 nm long (Figure 1a is a cross section along the gate length, and gates typically have widths much greater than their lengths). An alternative would be formation of polysilicon gates followed by a self-aligned silicidation (after the source/drain and sidewall dielectric formations of the next step) to create a silicide on both the gate top and the source/drains.

(2) Perform lightly doped drain implants, and then form sidewall dielectric on the gates by deposition plus anisotropic etching. Introduce dopants to form sources and drains 114. Cover the gate level structure with a planarized dielectric layer 120 (such as BPSG or a stack of conformal and planarized layers including undoped oxide such as a deposition from TEOS); see Figure 1b.

(3) For a structure with an embedded memory cell array using one-transistor one-capacitor memory cells, the bitlines and cell capacitors may be formed next. For clarity such steps are not illustrated and attendant additional dielectrics deposited on dielectric 120 will just be considered part of dielectric 120.

(4) Photolithographically define and etch holes (contacts, vias) in planarized dielectric 120 down to selected source/drains 114 and locations on gate level interconnects 112 (and also to selected bitline locations for embedded memory). Blanket deposit (including filling vias) a metal stack such as 50 nm of Ti, 50 nm of TiN, 500 nm of W or Al (doped with Cu and Si), and 50 nm of TiN; the bottom Ti and TiN form a diffusion barrier and the top TiN forms an antirefletive coating for lithography. Prior to the W or Al deposition the bottom Ti may be reacted with the source/drain to form a silicide to stabilize the metal-to-silicon contact. The Ti and TiN may be deposited by physical vapor deposition (PVD) or chemical vapor deposition (CVD) (e.g., $TiC14 + NH3 \rightarrow TiN + HCl$); the aluminum may be deposited by PCD and then forced into the vias under high pressure or by CVD; and W may be deposited by CVD. Alternatively, the vias may be filled with W by a CVD blanket deposition followed by an etchback to leave W only in the vias ( W plug), and then blanket Ti, TiN, Al, and TiN depositions.

(5) Photolithographically define and etch the first level metal to form first level interconnects 130; see Figure lc. The gaps between adjacent interconnects 130 may be on the order of 200-300 nm, and these minimal gaps dominate the capacitive couplings.

(6) Deposit a 50 nm thick conformal oxide liner 140 on interconnects 130 plus exposed dielectric 120 by plasma-enhanced decomposition of TEOS with oxygen or ozone. Liner 140 passivates the metal surfaces and prevents

diffusion of metal along the pores of the subsequently deposited xerogel. It also provides mechanical strength to suppress electromigration and suppress interconnect-to-interconnect leakage current. Other dielectric liner materials may be used, but the liner material contributes to the effective dielectric constant between the minimal gaps. Thus high dielectric constant liner material must be very thin.

(7) Spin coat liner 140 with a solution of xerogel precursor (e.g., oligomers condensed from hydrolyzed TEOS monomers in an ethanol plus ethylene glycol or other polynol solvent) but without added catalyst such as HCl or NH4OH. The viscosity of the coating solution determines the planarity of the resulting xerogel as described in the viscosity section below. The spun on coating 142 may be thick enough to: cover the tops of the interconnects 130 by roughly 100 nm, fill the minimal gaps, and be roughly 300 nm thick in open areas between interconnects. About 3 ml of precursor on a 200 mm diameter (8 inch) wafer suffices; see Figure 1d. The ethanol quickly evaporates and the spin speed can be increased to planarize; see the following Viscosity section for details.

(8) Age the coated solution on the wafer at room temperature in an NH3 + H2O atmosphere for about 1.5 minutes. The NH3 (and H2O) dissolves in the coated solution and catalyzes the gelling (polymerization of the oligomers into polymers). Maintain a steady ratio NH3 + H2O atmosphere during the aging by using an aging chamber system as illustrated in cross sectional elevation and plan views in Figures 1h-i with a continuous flow of NH3 + H2O gas mixture. For 200 mm wafers, aging chamber 190 has a diameter of roughly 220mm and a height of roughly 5 mm with densely and uniformly distributed gas inlets about the bottom periphery and a central gas outlet in the removable top. The wafer can sit upon some pins extending from the bottom of chamber 190 or the wafer could be held down by a wafer chuck formed in the bottom of chamber 190. Chamber 190 can be integrated into a standard spin-on-glass track system so that all of the processing steps may be fully automated. Flowing a gas mixture having a constant NH3 to H2O ratio (as could be generated by bubbling NH3 through an NH4OH solution) over the coated solution will reduce the exchange time with air after each insertion of a new wafer into the chamber and also speed up the exchange of fresh NH3 + H2O with the layer of coated solution immediately above the wafer surface. The NH3 flow rate into the bubbler may be in the range of 0.5 to 10 liters per minute; this implies a flushing of chamber 190 roughly every 1 to 23 seconds. The pressure in aging chamber 190 is slightly over atmospheric, and the NH3 to H2O ratio can be in the range of 40 to 100. At room temperature NH3 is in gas phase and the vapor pressure of H2O is about 15 Torr; the vapor pressure ratio of NH3 to H2O over saturated aqueous NH4OH is roughly 40 to 1.

Figure 1j shows an alternative to the bubbler system of Figure li which uses a vaporizer with separately-controlled NH3 and H2O inputs to generate a constant NH3 to H2O ratio mixture to inject into aging chamber 190. In this system the NH3 input is in gas form, and the H20 input is in liquid form. The partial pressure ratio of NH3 to H2O can be in the range of 10 to 100 (so the gas is primarily NH3), and the NH3 flow can be in the range of 0.5 to 10 liters per minute as with the bubbler system. This system allows a wider range of control of the NH3 to H2O vapor ratio.

The foregoing ammonia catalyst could be replaced with other catalysts deliverable in gas form. For example, HC1 or HC1 + H2O could also used in similar systems.

The foregoing systems of continuous gaseous catalyst delivery to the coated wafer can be modified to increase the gel reaction rate by heating the coated wafer to 100 C. However, the high temperature will increase solvent (e.g., ethylene glycol) evaporation which may lead to polymer network collapse. Thus include saturated solvent vapor in the gaseous catalyst flow. Note that ethanol will rapidly evaporate even at room temperature in the foregoing systems, and only the low vapor pressure component of the solvent need be injected. For a bubbler system, the NH3 + H2O gas could be generated in an NH40H bubbler and then be used to bubble through an ethylene glycol bubbler at 100 C and then injected into aging chamber 190. The vaporizer system could simply have a third input for the ethylene glycol plus heat the gas mixture to the temperature of the aging chamber or higher. A gas mixture at atmospheric pressure and 100 C of roughly 90% NH3, 8% H20, and 2% ethylene glycol would provide both the catalyst and saturated solvent (at 100 C the vapor pressure of ethylene glycol is about 16 Torr). The water temperature cannot be too high; high temperatures reduce the solubility of NH3 in H20 and the pH values of NH4OH solution plus decrease its catalytic effect.

(9) Replace the solvent in the polymer network pores (primarily ethylene glycol) with ethanol or some other low surface tension liquid by continuous spin rinsing with ethanol. The spin rinsing for a 200 mm wafer can be performed in 10-30 seconds at spin speeds of 100-400 rpm and an ethanol dispensing rate of 0.5 to 2.0 liters per minute. Without this replacement the high surface tension of the original solvent may (partially) collapse the polymer network during solvent evaporation due to surface tension within the drying pores. However, if the polymer network is strong enough to withstand the surface tension, then this step could be omitted.

(10) Spin a source of hydrophobic groups, such as hexamethyldisilizane (HMDS), onto the solvent-exchanged gel of the preceding step to convert any remaining hydroxyl groups on the polymer network to hydrophobic groups, such as trimethylsilyl groups. The spin rinsing with HMDS for a 200 mm wafer can be performed in 10-30 seconds at spin speeds of 100-400 rpm and an HMDS dispensing rate of 0.5 to 2.0 liters per minute. The reaction could be of the type:

$$\equiv SiOH + (CH3)3Si\text{-}NH\text{-}Si(CH3)3 \rightarrow \equiv Si\text{-}O\text{-}Si(CH3)3 + NH3$$

Typically, the overall hydrolysis plus condensation reaction converts roughly 70% of the ethoxysilicon bonds of the TEOS to siloxane bonds and the remaining 30% of the ethoxysilicon bonds mostly into silanol bonds. The hydrophobic group substitution eliminates most of these silanol bonds. The silanol groups are hydrophilic and induce higher dielectric constants and cause potential metal corrosion problems. However, if hydrolysis plus condensation produces only a small number of hydroxyl groups, then this step could be omitted.

(11) Spin rinse the wafer with a low surface-tension liquid such as hexane. The spin rinsing for a 200 mm wafer can be performed in 10-30 seconds at spin speeds of 100-400 rpm and a hexane dispensing rate of 0.5 to 2.0 liters per minute. If the polymer network of the gel is strong enough, then this solvent exchange may be omitted. A final 5-10 second spin at 1000-3000 rpm helps to start drying the gel. The three spin rinsing steps (solvent exchange, hydrophobic group substitution, and final solvent exchange) can all be done in succession in the same spin coating cup used for the original precursor coating, a separate cup, or even in a photoresist development cup.

Then evaporate the majority of the hexane by heating the wafer to 300-350 C for about 60 seconds to dry the gel and thereby form a xerogel which consists of the polymer network with vapors/air in the pores. The xerogel may be 50-90% pores and 10-50% polymer network by volume with the pores having an average diameter on the order of 10-20 nm.

The drying may be automated and integrated with the spin coating, aging, and spin rinsing as illustrated in plan view in Figure 1k.

(12) Further dry the hydrophobic xerogel in a reducing atmosphere of forming gas (95% N2 + 5% H2) at 425 C for 30 minutes. The drying drives residual liquid out of the xerogel pores. The Drying section below describes alternative drying environments.

Note that the xerogel in the gaps between interconnects is constrained by the surrounding surfaces and cannot shrink (without pulling loose from a surface), whereas the overlying xerogel may shrink down without constraint. Thus the relative pore volume in the gaps may be higher than the relative pore volume above the interconnects, and thus the dielectric constant may be lower in the gaps than above the interconnects.

(13) Etchback the xerogel 142 about 100 nm to expose the liner on the tops of the interconnects 130; see Figure le. The etchback may be by a fluorine-based plasma. This etchback to clear the xerogel from the tops of the interconnects 130 has the advantage that vias in the next level of interconnects will not have to be etched through xerogel, so lateral etching control may be simple and outgassing from the xerogel into etched vias will not be a problem.

(14) Spin on 200-300 nm average thickness layer 144 of hydrogen silsesquioxane (HSQ) and cure it at 400 C. HSQ layer 144 adheres to underlying xerogel 142 (probably by filling open pores at the surface) and provides a good surface for subsequent deposition of a thick capping dielectric; see Figure le. Without HSQ adhesion layer 144, the hydrophobic surface of xerogel 142 would provide poor adhesion for oxide deposited by plasma-enhanced TEOS decomposition. The Adhesion sections below describes further xerogel surface adhesion enhancement preferred embodiments.

(15) Deposit a 1500 nm thick dielectric 146 on the HSQ surface by plasma enhanced decomposition of TEOS with oxygen or ozone. Then planarize dielectric 146 with chemical mechanical polishing (CMP) to provide for an intermetal level dielectric thickness of about 1000 nm. This completes the first metal level interconnects; and further levels result from repetition steps (4)-(15) where the vias in the planarized dielectric extend down to immediately underlying interconnects. Note that a via may effectively extend through two or more levels by simply forming a vertical stack of vias and overlying small metal patches.

The preceding preferred embodiment etched back the xerogel in step (13) to expose the liner on top of the interconnects. In contrast, the non-etchback preferred embodiment omits this etchback step and spins on the adhesion layer (e.g., HSQ) immediately after completion of the xerogel drying. Thus follow preceding steps (1)-(12), corresponding to Figures 1a-d, skip step (13), and continue with step (14). See Figure 2a showing 100-nm-average-thickness adhesion layer 244 on as deposited xerogel 242 with 700 nm thick planarized dielectric layer 246 on the adhesion layer.

As in preceding preferred embodiment step (15), next define and etch vias through dielectric 246, adhesion layer 244, xerogel 242, and liner 140 down to interconnects 130. Note that the via etch only goes through about 100 nm of xerogel 242. Experimentally, the exposed xerogel appears not to contaminate the via bottom, and TiN or Ti/TIN barrier of interconnect 260 makes a good interface with xerogel 242.

Of course, most of the via sidewall is oxide 246, so even poor adhesion to xerogel 242 by the barrier layer does not present a problem. Interconnects 260 are patterned, liner 270 deposited, second level xerogel 272 formed, HSQ adhesion layer 274 spun on, and capping oxide 276 deposited in the same manner as the corresponding components of the gapfill with etchback preferred embodiment previously described; see Figure 2b

A further preferred embodiment uses xerogel dielectric in a damascene approach as illustrated in Figures 3a-f. In particular, begin with steps (1)-(4) of the gapfill preferred embodiments (Figures 1a-b), and in place of step (5) (patterning the blanket metal to form the first level interconnects) etchback the blanket metal to leave metal only in the vias; see Figure 3a showing metal plugs 330 in the vias. The metal etchback may be, for example, by (isotropic) plasma etch (endpoint by loading drop) or by CMP. Alternatively, fill the vias by the same approach using doped polysilicon rather than metal: a blanket deposition of in situ doped polysilicon which fills the vias followed by an etchback to remove the polysilicon outside of the vias.

After via fill, spin on xerogel precursor solution (plus catalyst if necessary) and process as in preceding gapfill preferred embodiment steps (7)-(12) to form 700 nm thick xerogel layer 342.

Next, photolithographically define the locations of interconnects and etch trenches 341 in the xerogel down to dielectric 120 or plugs 330 at these locations; see Figure 3b. The minimal spacing between adjacent trenches is about 200-300 nm, so the free-standing xerogel strips 343 have an aspect ratio of roughly 3 to 1. The etch may be an anisotropic fluorine-based plasma etch, such as CF4 + CHF3 + He + Ar. Because the xerogel has high porosity, it etches much faster than oxide, so an overetch will not remove much of underlying dielectric 120 even if dielectric 120 is oxide. Alternatively, dielectric 120 could have a nitride upper portion to provide a more selective etchstop for the xerogel trench etch.

Blanket deposit 20-50 nm thick TiN conformal barrier layer 350 by PVD or CVD. Other barrier materials include TaN, Ta2N, W2N and TiSiN (which can be formed by silane treatment of amorphous TiN). The hydrophobic surface of xerogel 342 may not provide sufficient adhesion for the barrier layer, so activate the xerogel surface by removing the hydrophobic methyl groups in a hydrogen-containing plasma. The adhesion sections below describe surface activation embodiments. Also, CVD TiN provides better sidewall coverage than PVD, so use a CVD process such as ammonia plus tetrakisdimethylamino titanium (TDMAT).

Deposit (e.g., electroplate, CVD, PVD) 200 nm thick copper layer 352 on the TiN; this fills the interconnect trenches etched in the xerogel 342 in the previous step plus covers the remainder of the wafer. See Figure 3c.

Remove the portion of copper 352 outside of the interconnects by CMP; the CMP also planarizes any bumpiness in the plated copper. Alternatively, use a halogen plasma etch of copper, but these etches typically have fairly low etch rates because, for example, copper chloride tends to polymerize. CuCl can be removed with a strong Lewis acid such as triethylphosphine which reacts to form the gas ClCu(PEt3)2. Barrier layer 350 may also be a CMP polish stop; in this case the barrier must be etched off after the polishing. This CMP (or etching) leaves copper only as interconnect 352.

After the copper polishing, deposit 700 nm thick dielectric layer 360; see Figure 3d. The dielectric may be oxide and deposited by plasma enhanced TEOS decomposition with oxygen or ozone. This completes the first level interconnect (analogous to Figure lf), and repetition of the foregoing steps (via etch and fill, xerogel deposition, trench etch, trench fill, and dielectric deposition) provides further interconnect levels.

An alternative structure for more protection of the xerogel from CMP damage includes forming a 100 nm thick oxide layer 346 (on adhesion layer 344) on xerogel 342 surface prior to interconnect trench etch. In this case the trenches are etched through both the oxide (plus adhesion layer) and the xerogel; see Figure 3e. Then follow the previously-described steps: barrier deposition, copper electroplating, and CMP to remove the copper outside of the interconnects. The CMP can remove a portion (or all) of the oxide plus adhesion layer, but the oxide (plus adhesion layer) protect the xerogel from exposure to the CMP; see Figure 3f. Of course, a thick adhesion layer which also provides good CMP properties could be used in place of a thin adhesion layer plus deposited oxide.

Further levels of interconnects can be made by repeating the steps of etch vias in the dielectric on the xerogel plus top level interconnects, fill the vias, form xerogel layer, pattern interconnects in the xerogel, deposit blanket metal, polish to complete interconnects, and deposit overlying dielectric.

A further preferred embodiment deposits oxide over the interconnects, etches trenches between minimally spaced interconnects, and then fills the trenches with xerogel by a spin on and etchback. In particular, Figures 4a-c illustrate this approach. Figure 4a shows trenches 441 which have been etched in planarized oxide 440 and between minimally spaced adjacent interconnects 430. Again, interconnects 430 may be 700 nm high and 200 nm wide with the minimal spacing of 200 nm.

Next, spin on a xerogel precursor solution which fills trenches 441 plus the horizontal portions of oxide 440, and then react to form the gel and dry to form xerogel 442. Etchback xerogel 442 (fluorine-based plasma) to remove all of the xerogel outside of the trenches; see Figure 4b.

Deposit and planarize thick oxide 460 on oxide 440 and xerogel 442, the poor adhesion to xerogel 442 is not a problem because of the large oxide 440 area. Etch vias in oxide 460 down to interconnects 430, and deposit and pattern metal to form interconnects 470; see Figure 4c. This approach only has xerogel in minimal gaps between adjacent interconnects; of course, this is where the xerogel has the most effect in lowering capacitive coupling.

Interconnects 430 could have a silicon nitride liner; this permits selective oxide etching the trenches in the minimal gaps between adjacent interconnects and leave the nitride liner to protect xerogel 442 from metal interconnects

430. However, such a liner will increase the effective dielectric constant between the adjacent interconnects.

HSQ adhesion layer 144 of the preferred embodiments could be replaced by layers of other materials which also have good gap fill properties. In particular, the average pore size of xerogel varies with the dielectric constant, and for dielectric constants about 1.5 to 2.0 the average pore size is on the order of 10 to 25 nm. Thus a material which is depositable to fill open pores of this size at the surface will have a large contact area to bind to the xerogel plus will have mechanical interlocking to increase adhesion. Figure 5 illustrates in cross sectional elevation view the open pore filling. Figure 5 shows xerogel 510 including interior pores 512 away from the surface and pores 514-516 open at the surface; gapfill material layer 520 fills essentially all of pore 516 but only roughly half of pore 514. If the gapfill material fills roughly 50% or more of the volume of the average open pores at the surface, then the contact area increase and mechanical interlocking are significant. So a gapfilling material which provides a good surface for subsequent thick dielectric deposition may be used as an adhesion layer material.

For plasma enhanced TEOS oxide (or fluorinated oxide) thick dielectric, the following materials should sufficiently fill the open pores at the xerogel surface and provide the adhesion layer: HSQ, subatmospheric ozone TEOS based CVD (SACVD), methyl silsesquioxane, Flow Fill oxide (spin on silanol from silane in hydrogen peroxide at a temperature of 0 C), and so forth.

Rather than apply a pore filling material such as HSQ 144 to xerogel 142 as in previous preferred embodiments to provide adhesion for deposited dielectric, an alternative preferred embodiment enhances the surface adhesion of xerogel by activating the xerogel surface with a plasma of 10-90% hydrogen and remainder argon for 1 minute with a pressure in the range of 0.1-5 Torr. The low energy plasma hydrogen removes the surface methyl groups of the hydrophobic xerogel with a net reaction such as:

$$-Si(CH3)3 + 6H \rightarrow -SiH3 + 3CH4$$

The hydrided silicon surface provides good adhesion to both deposited (fluorinated) oxides and other dielectrics such as organic polymers like parylenes.

Further, the hydrogen plasma treatment can be performed in the same chamber as the subsequent plasma-enhanced oxide deposition; so the hydrogen plasma adds little processing complexity.

The plasma activated xerogel surface also provides good adhesion for deposition of barriers such as TiN and Ta2N as used in the previously-described damascene interconnect structure.

Plasma surface treatment with plasmas based on other source gasses such as NH3, O2, ... also activate the surface by reactions like:

$$-Si(CH3)3 + NH3 \rightarrow -Si(NH2)3 + CH4$$

$$-Si(CH3)3 + O2 \rightarrow -SiO + CO2 + H2O$$

An alternative xerogel surface enhancement collapses a thin layer of the xerogel at the surface to form a relatively continuous shell; the shell provides a large contact area for deposited layers. See Figure 6 illustrating the continuous surface of the shell with collapsed pores near the surface. To form the shell, exposes the xerogel surface to ion beam bombardment. Typically, an ion implanter using an argon ion beam with a dose of $10^{16}/cm^2$ and an ion energy of 20 keV; alternatively, an argon plasma could provide the ion bombardment. The hard shell will be about 20-50 nm thick. The hard shell provides good surface adhesion for plasma-enhanced deposited oxide.

In effect, if the average pore diameter were D, then the portion of the xerogel within a distance of 2D of the surface would have a porosity (ratio of total pore volume to total volume) of much less than half of the porosity away from the surface.

The drying of the gel in foregoing preferred embodiment step (12) could also be accomplished at other temperatures and with other reducing atmospheres at various pressures. The reducing atmosphere apparently helps remove residual adsorbants which may be partially oxidized. This treatment brings the dielectric constant down to a stable minimum for the xerogel.

In particular, heating in the range of 400-500 C for 1-60 minutes suffices for xerogel thicknesses up to 1 μm with the longer times for the lower temperatures. Typically, integrated circuit processes will have a thermal budget and an upper limit for temperature, and thus a lower temperature but longer drying may be required. However, drying with the same conditions as used for other heat treatments, such as 430 C for 30 minutes aluminum sintering in forming gas, would be convenient.

The reducing atmosphere could be at a pressure of 1 mTorr to 10 Torr and the gasses could be H2 with an

inert gas (N2, Ar, He, ....) in various proportions. Other reducing gasses such as CH4, NH3, ... are possible.

Spin on dielectric solutions typically consist of two components: a dissolved solid and a solvent. During the spin on process, most of the solvent evaporates leaving a greater than 90% solids content film which is subsequently polymerized during hot plate or furnace bakes. The initial solids content must be relatively small (less than 30%) to insure film thickness uniformity across the wafer and good gapfill of high aspect ratio features. This low solids content generally implies low viscosity and poor planarization.

The preferred embodiment precursor solution as used in the preceding preferred embodiments can be thought to have three components: a high vapor pressure solvent (ethanol), a low vapor pressure solvent (a polynol such as ethylene glycol), and the TEOS oligomers; the volume percentages are roughly 70% high vapor pressure solvent, 20% low vapor pressure solvent, and 10% oligomers. This three component system permits two independent stages of the spin on process. First, just as in the case of typical spin on dielectrics, the three component system can be adjusted to have low enough viscosity to insure thickness uniformity and good gapfill. However, once the high vapor pressure ethanol has evaporated, the lower vapor pressure polynol with dissolved oligomers is still a liquid just beginning to crosslink (polymerize). This viscous liquid has already achieved good wafer thickness uniformity and gapfill and can be spun at higher speeds to achieve better planarization. For example, the initial spin on may be at 1000 rpm and the second spin after ethanol evaporation may be at 5000 rpm. Note that the final xerogel film profile will be identical to the liquified profile of the polynol/oligomer liquid after the final spin process because the sol-gel process forms a cross-linked network throughout the entire liquid volume. The two solvent sol-gel process thus enables an effective decoupling of film thickness uniformity and gapfill from planarization.

The viscosity of the polynol/oligomer liquid can be adjusted either by appropriate choice of the polynol or of the time allowed for the crosslinking to proceed before final high speed spinning. Figures 7a-b illustrates the two stage spin on: Figure 7a shows the low viscosity three component system profile after spin on at low speed with the dotted line indicating the volume decrease when the high vapor pressure solvent evaporates; and Figure 7b shows the subsequent profile after high speed spin for planarization with the viscous liquid.

The reduced mechanical strength of xerogel compared to dense oxides imposes two potential problems at either stress concentration regions or regions with large mechanical stresses. In particular, any variation in underlying metal topography over a length scale greater than that of a few times the minimum metal pitch will result in xerogel thickness variations and initiation points for cracking. In addition, in the highly stressed bondpad regions of the chip, it would be preferable to minimize the thickness of the xerogel atop the bondpad. The preferred embodiments solve both of these problems with a combination of dummy metal in the open areas and slotted bondpads. An additional advantage of this architecture is the nearly constant height of the xerogel top surface with respect to the silicon surface. This greatly increases the process margin of the CMP process.

Figures 8a-b show in cross sectional elevation and plan view xerogel 820 on interconnects 810-812. The preferred embodiment interconnect structure adds electrically unconnected interconnects 850-852 to fill in open areas as between 810-811 and thereby planarize the xerogel as illustrated in Figures 8c-d. Indeed, interconnects 850-852 do not connect by vias to any other level interconnects and electrically float. Also, dummy interconnects need not be of the same width as electrically active interconnects and may be segmented as shown by 852-853. Indeed, arbitrary geometric patterns with not large open areas will suffice. The dummy interconnects may be more than the minimal gap from the closest active interconnect and still fill without significant surface sloping.

The planarized xerogel implies only a minimal amount of planarization need by used; in fact, using an HSQ adhesion layer will also sufficiently planarize to avoid CMP of the overlying deposited dielectric for the next level interconnects.

With damascene structure interconnects, dummy interconnects limit open areas of xerogel and add mechanical strength and thermal conductivity to the xerogel interconnect layer; recall Figures 3b-d. Further, the interconnects (electrically active plus dummy) can provide a polish stop for direct CMP without need for the oxide and adhesion layers as in Figures 3e-f. The dummy interconnects also provide vertical thermal conduits to avoid the limited thermal conductivity of the xerogel.

Laterally extended metal structures, such as bond pads, act like elevated open areas for the spin on xerogel and thus have a thicker top layer. To further planarize the spun on xerogel, preferred embodiment bond pads and other extended metal structures are formed as a series of interconnected interconnect segment as illustrated in Figure 8e.

The 50 nm oxide liner on the interconnects (see liner 140 in Figure 1d) could be replaced by other dielectric materials to lower effective dielectric constant. In particular, any conformally depositable material which does not react with the interconnect metal and to which xerogel will stick could be used. For example, parylene can be conformally deposited from the vapor phase, and the subsequent xerogel will stick to parylene. Other materials include fluorinated parylenes (e.g., AF4), ...

The preferred embodiments can be modified in various ways while retaining the features of surface adhesion, reducing atmosphere drying, and dummy interconnects with three component system for two stage spin on.

For example, the xerogel may be a hybrid organic-silica (replace the original TEOS with monomers such as

(EtO)3Si-R-Si(OEt)3 where R is a carbon linking group such as C6H4), the dimensions may be scaled.

## Claims

**1.** A dielectric layer fabrication method, comprising the steps of:

applying a layer of dielectric precursor on a body;
flowing a precursor reaction catalyst over said layer; and completing a precursor reaction to form a dielectric layer.

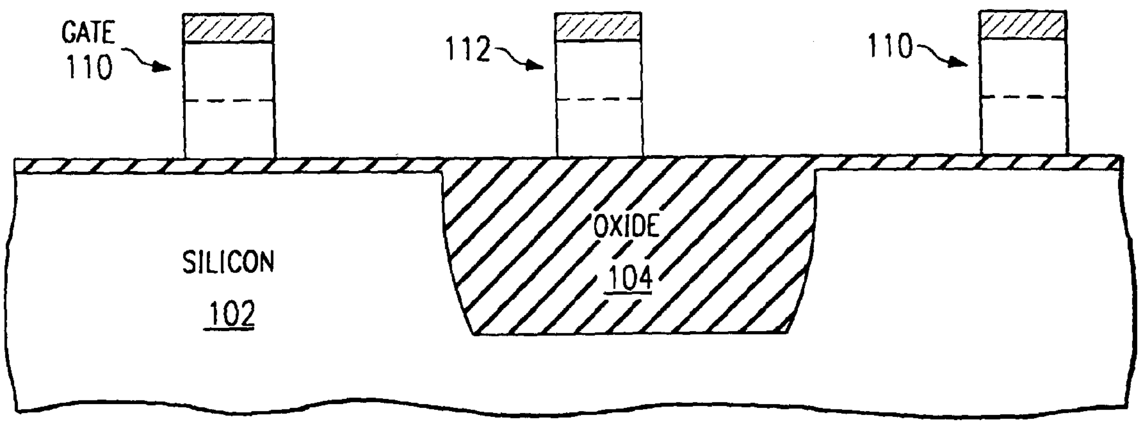
GATE
110
112
110
OXIDE
104
SILICON
102

FIG. 1a

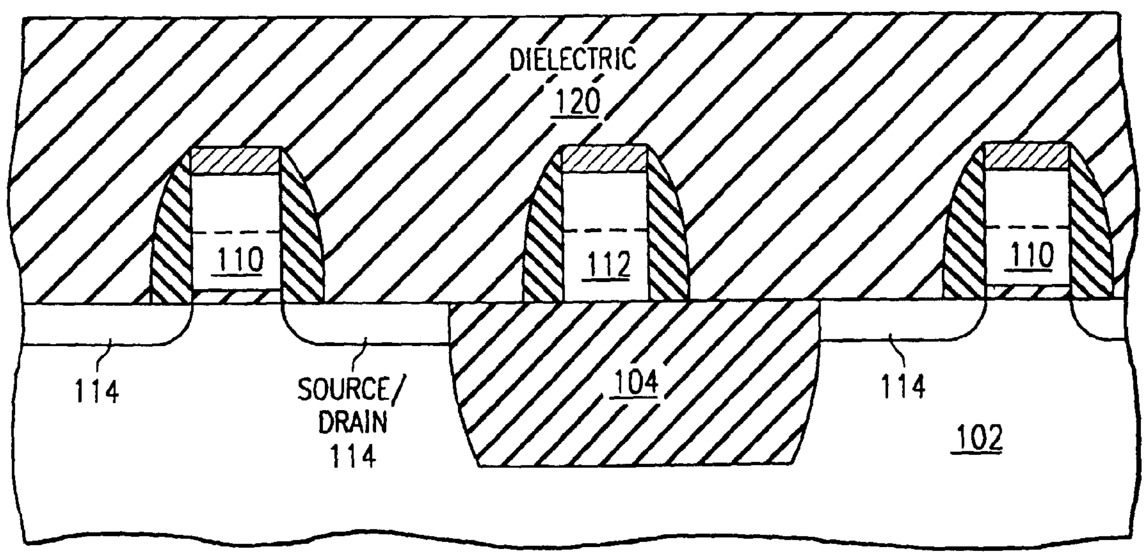
DIELECTRIC
120
110
112
110
114
SOURCE/
DRAIN
114
104
114
102

FIG. 1b

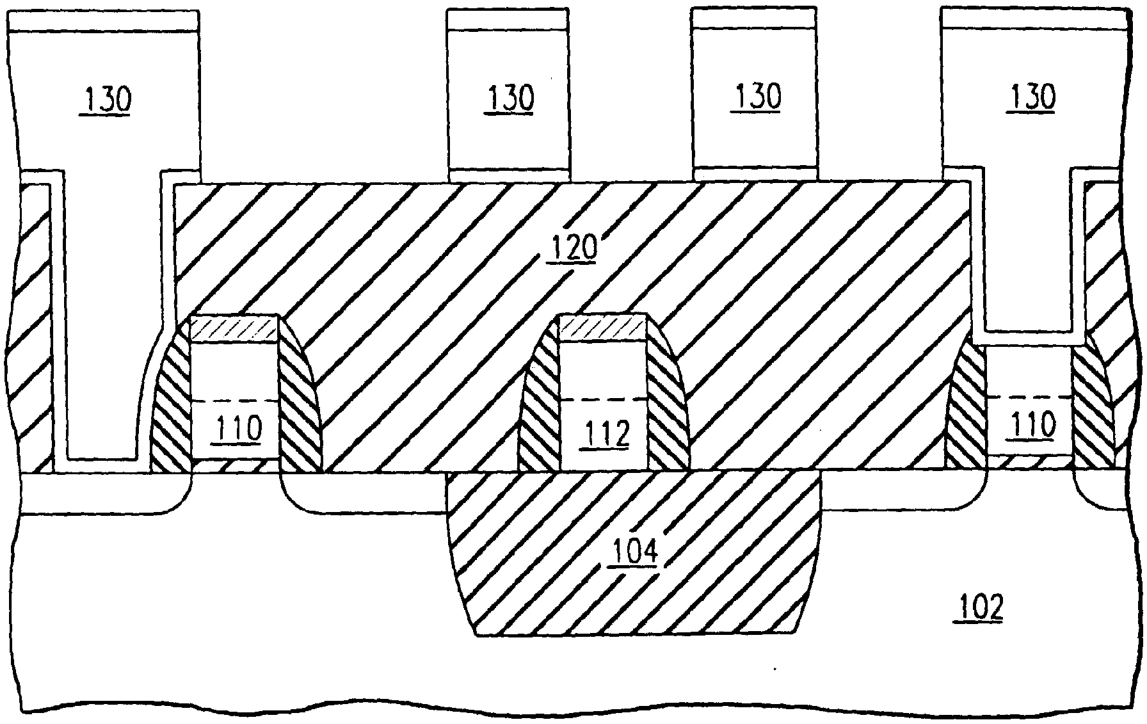
130
130
130
130
120
110
112
110
104
102

FIG. 1c

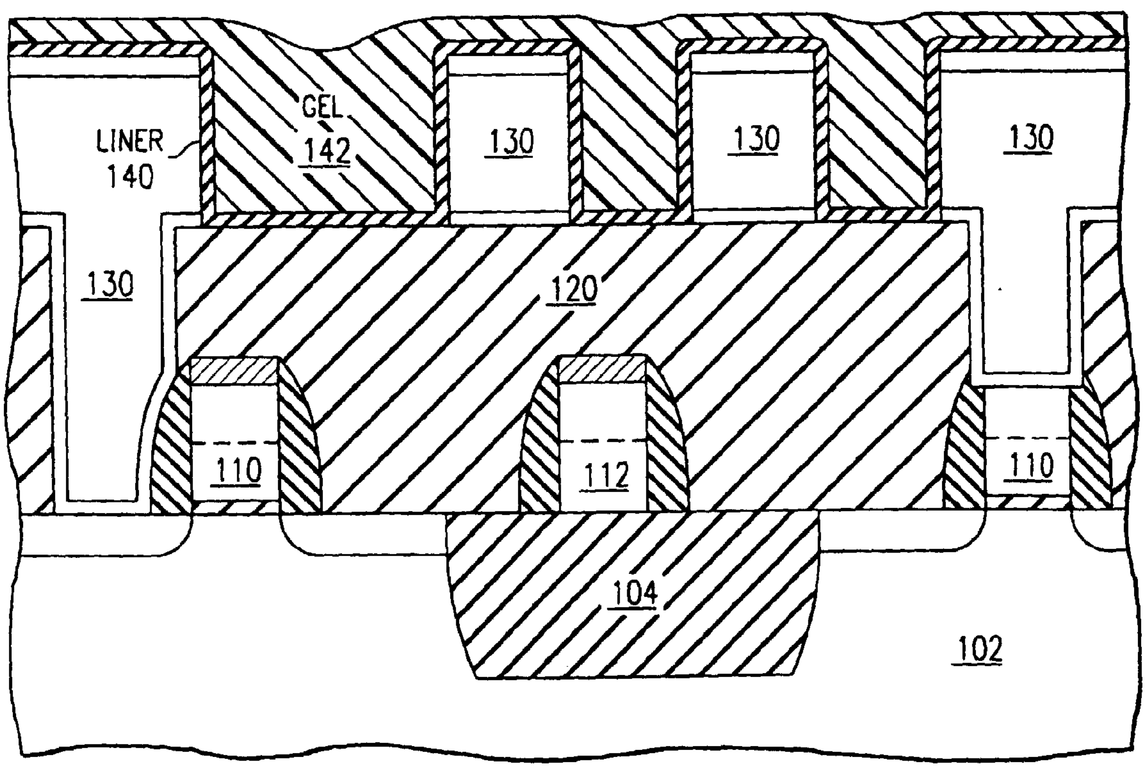
GEL
142
LINER
140
130
130
130
130
120
110
112
110
104
102

FIG. 1d

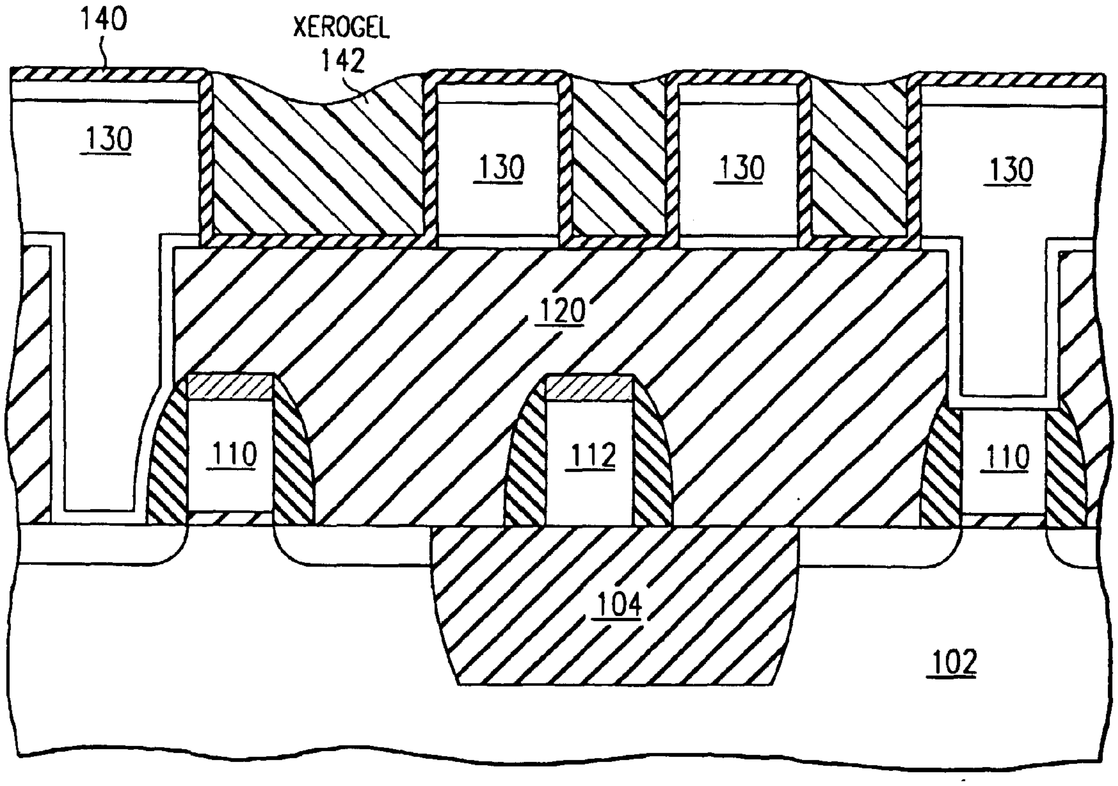


*FIG. 1e*

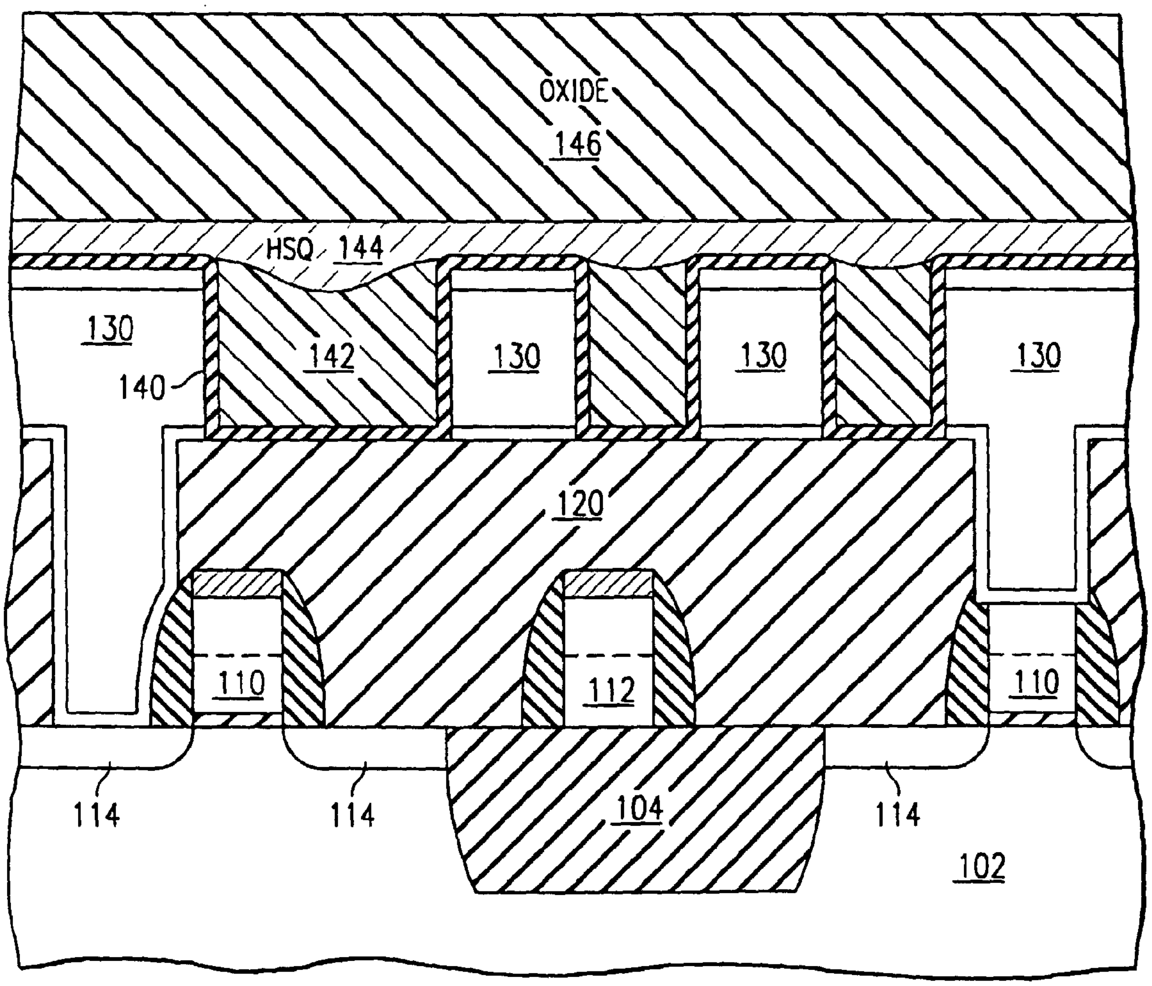
OXIDE
146
HSQ 144
130
142
130
130
130
140
120
110
112
110
114
114
104
114
102

FIG. 1f

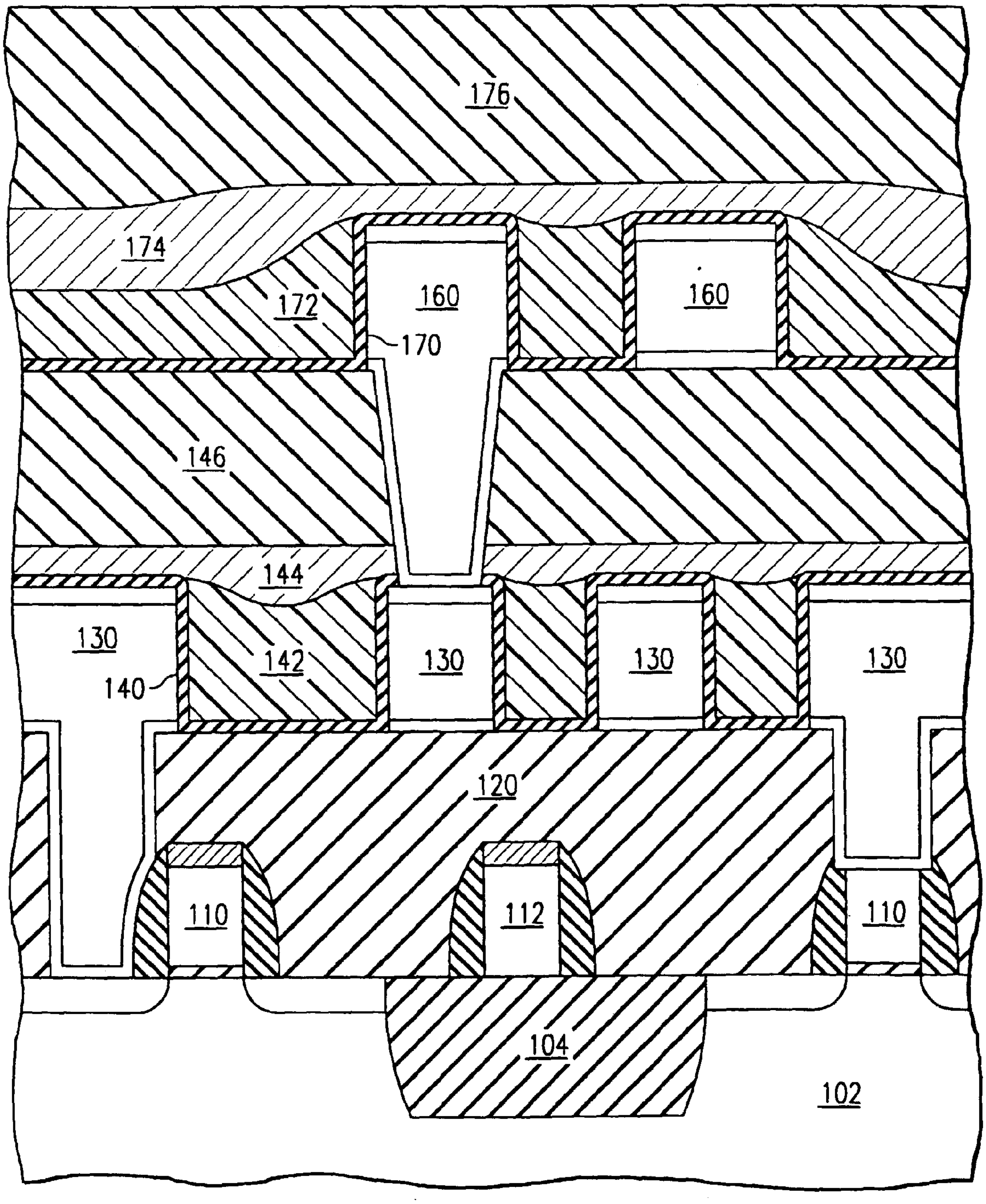
176
174
172
160
160
170
146
144
130
142
130
130
130
140
120
110
112
110
104
102

FIG. 1g

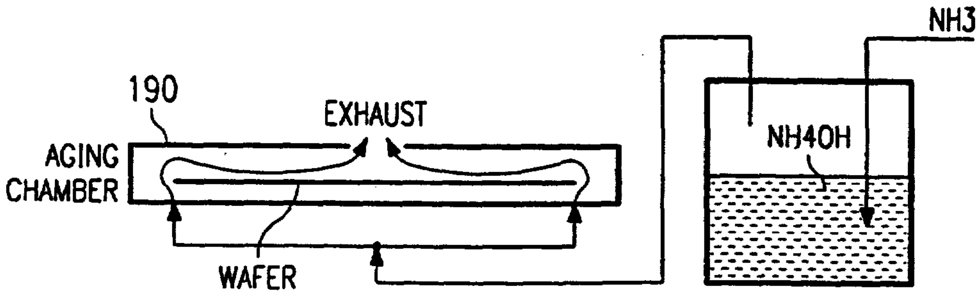


FIG. 1h

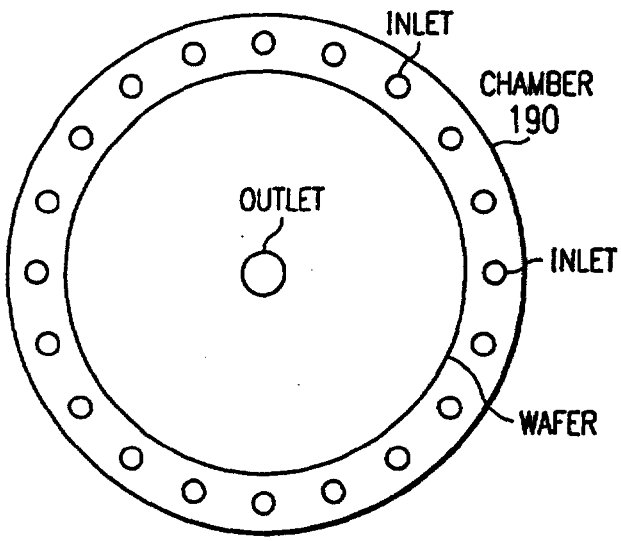


FIG. 1i

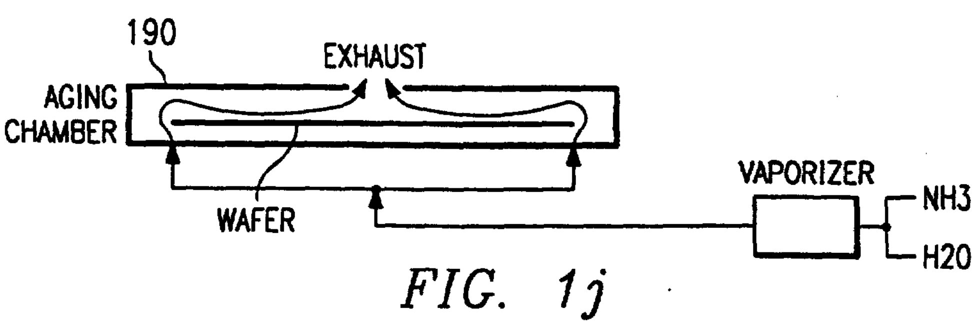


FIG. 1j

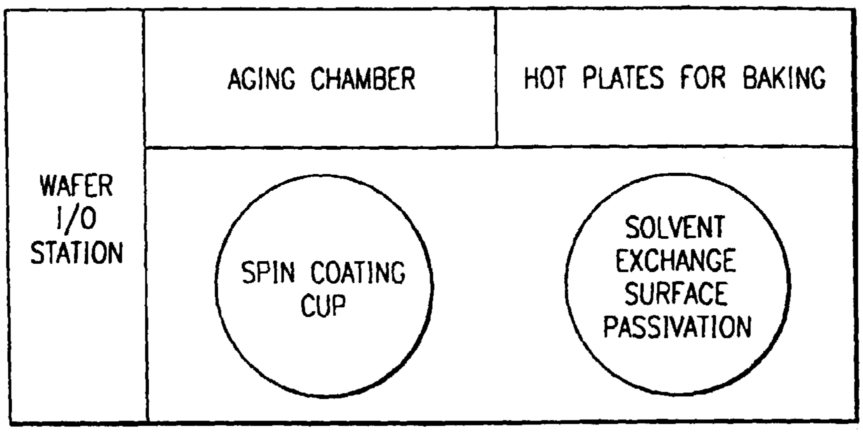
AGING CHAMBER
HOT PLATES FOR BAKING
WAFER I/O STATION
SPIN COATING CUP
SOLVENT EXCHANGE SURFACE PASSIVATION

*FIG. 1k*

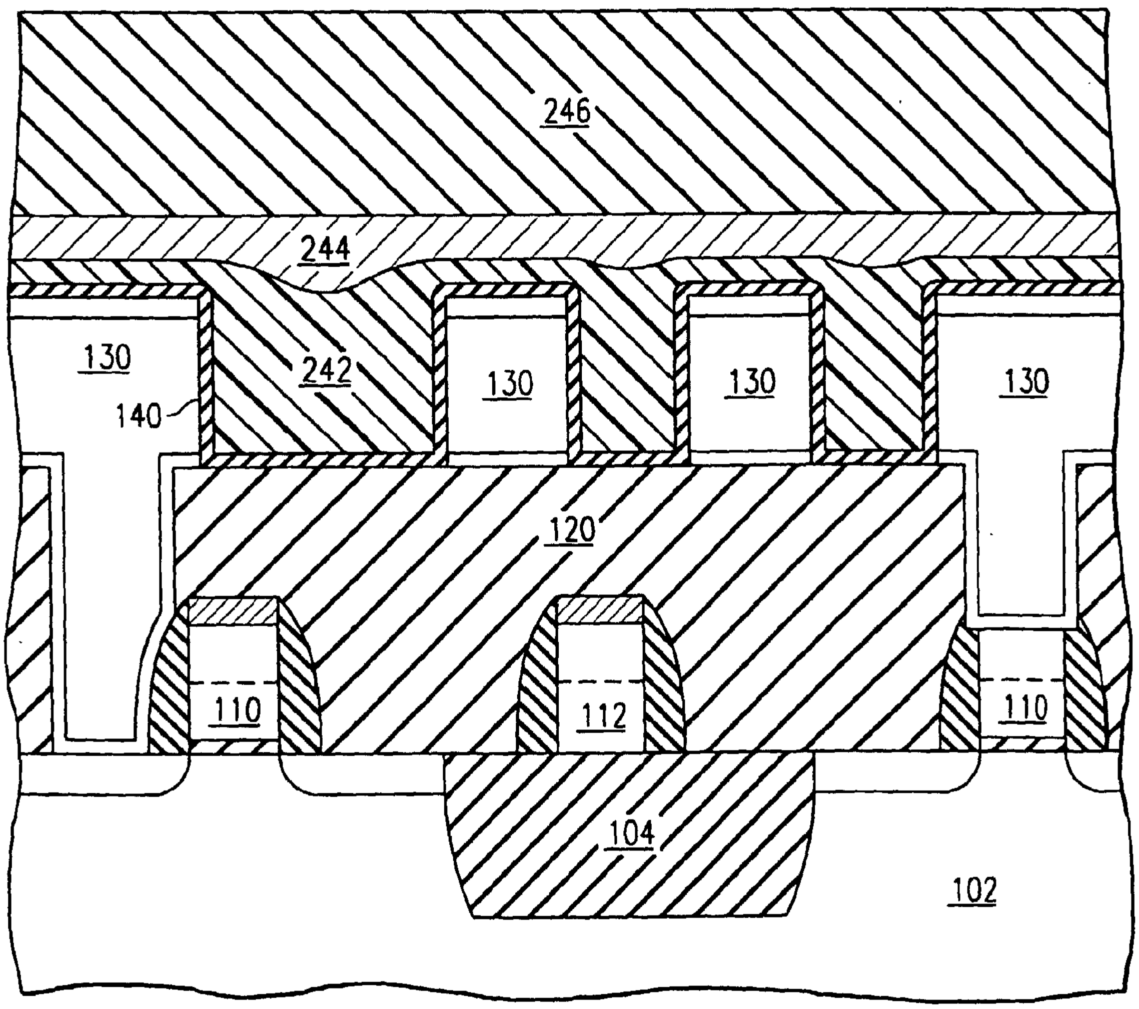
246
244
130
242
140
130
130
130
120
110
112
110
104
102

*FIG. 2a*

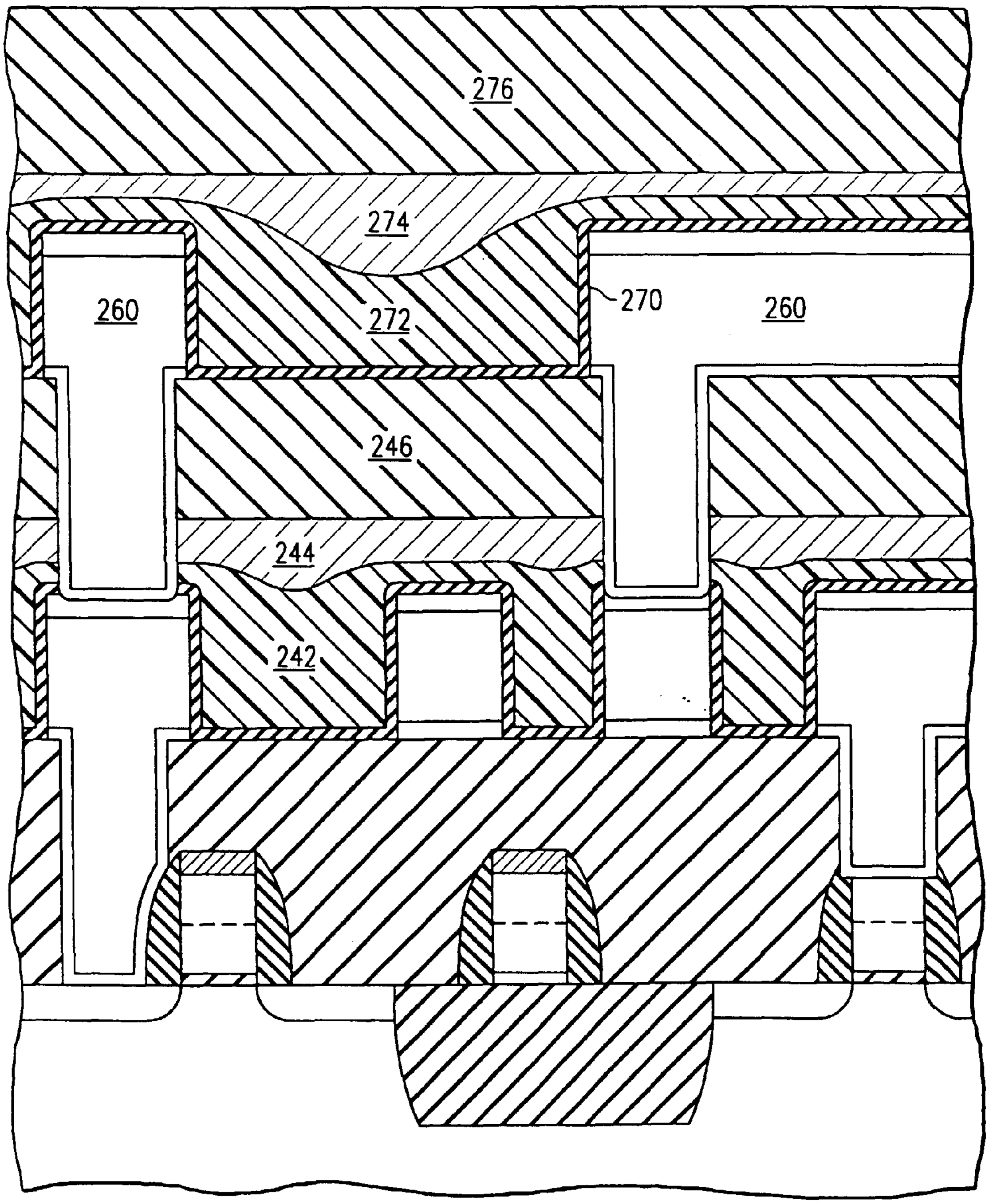


FIG. 2b

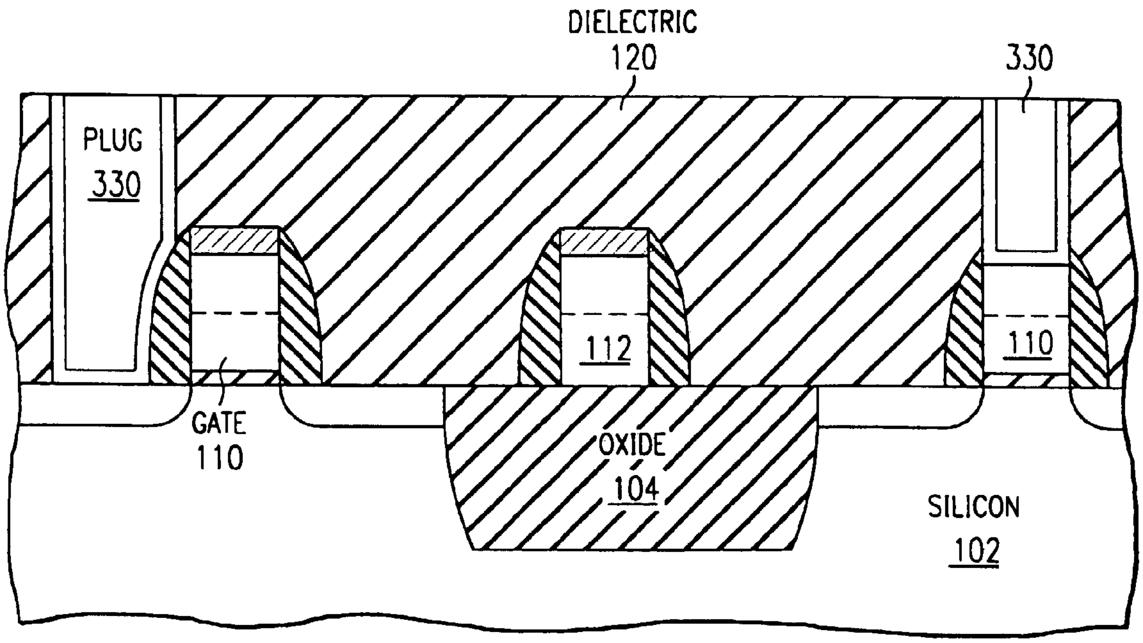
DIELECTRIC
120
330
PLUG
330
112
110
GATE
110
OXIDE
104
SILICON
102

*FIG. 3a*

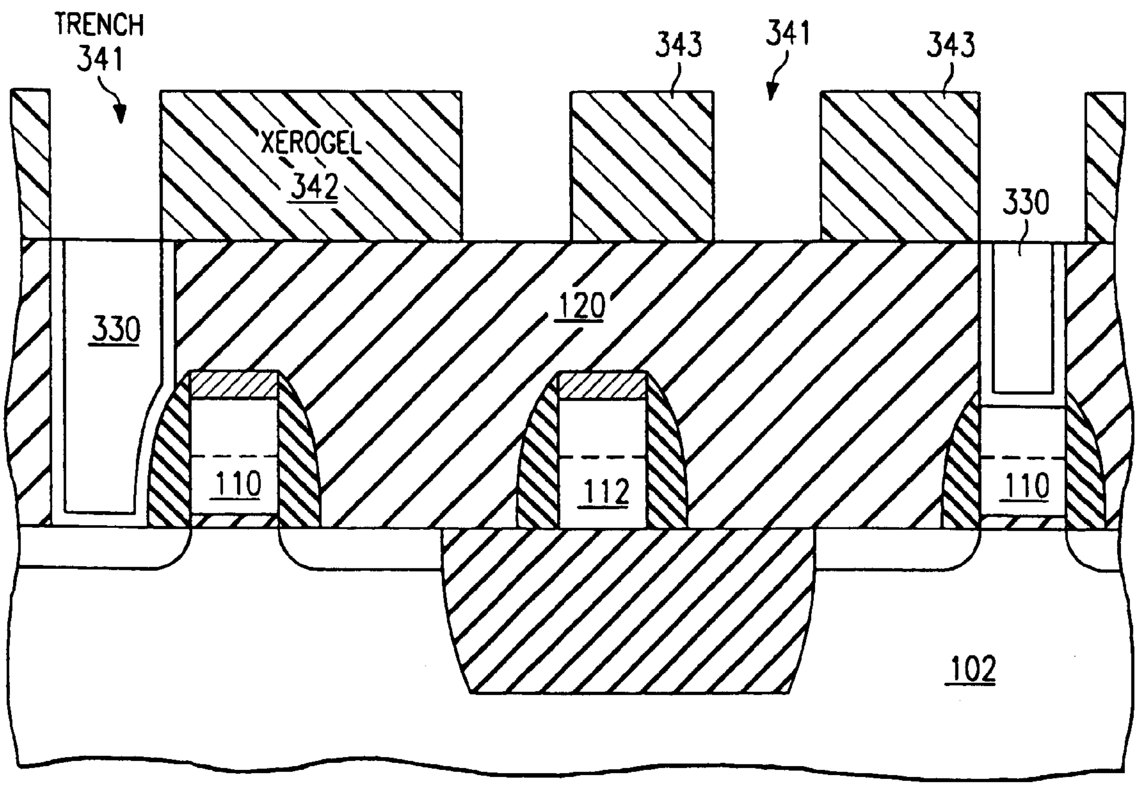
TRENCH
341
343
341
343
XEROGEL
342
330
330
120
110
112
110
102

*FIG. 3b*

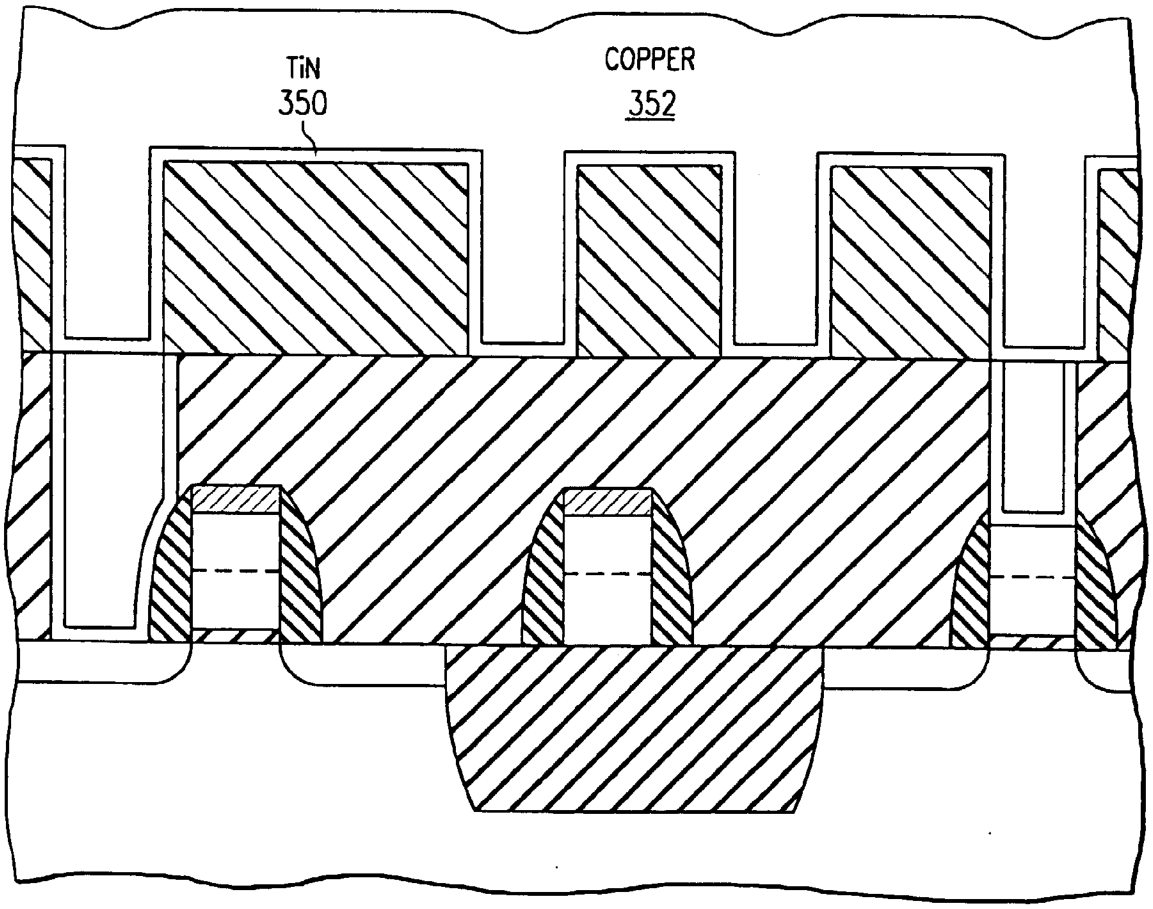


FIG. 3c

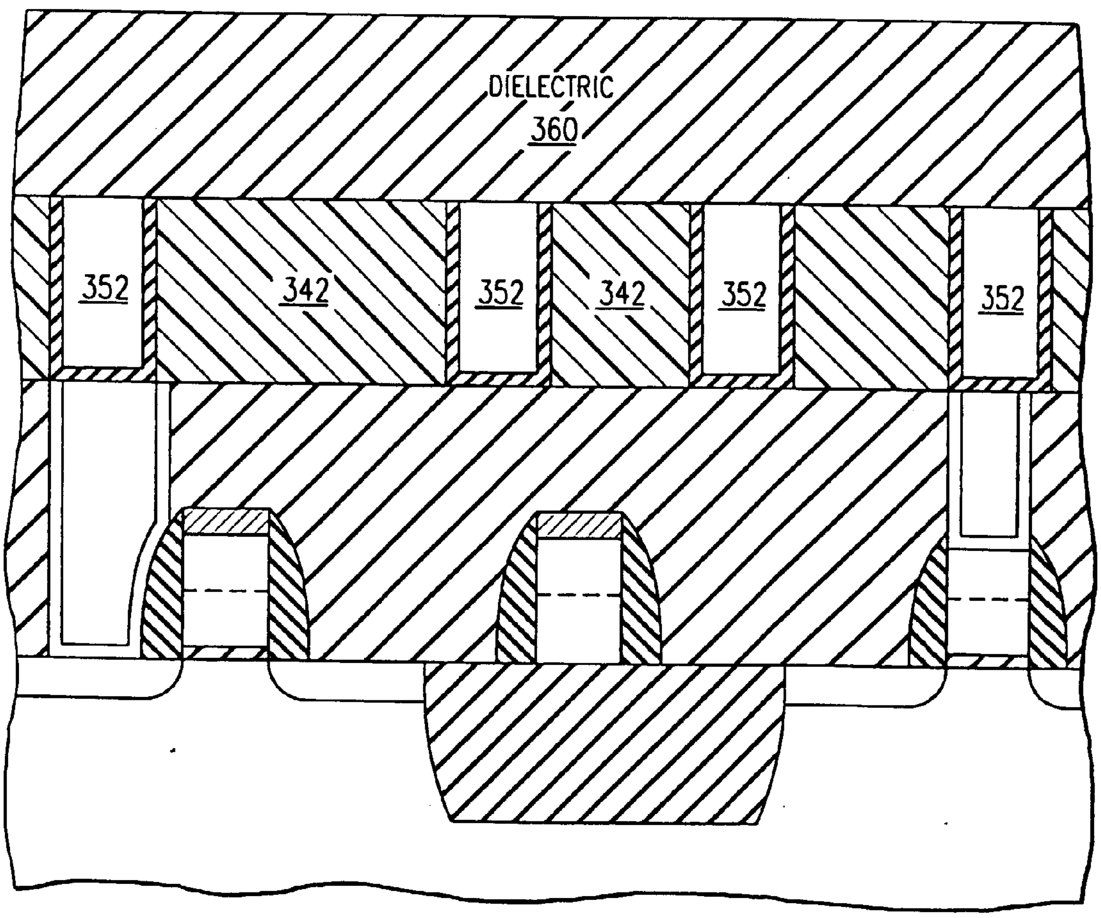


FIG. 3d

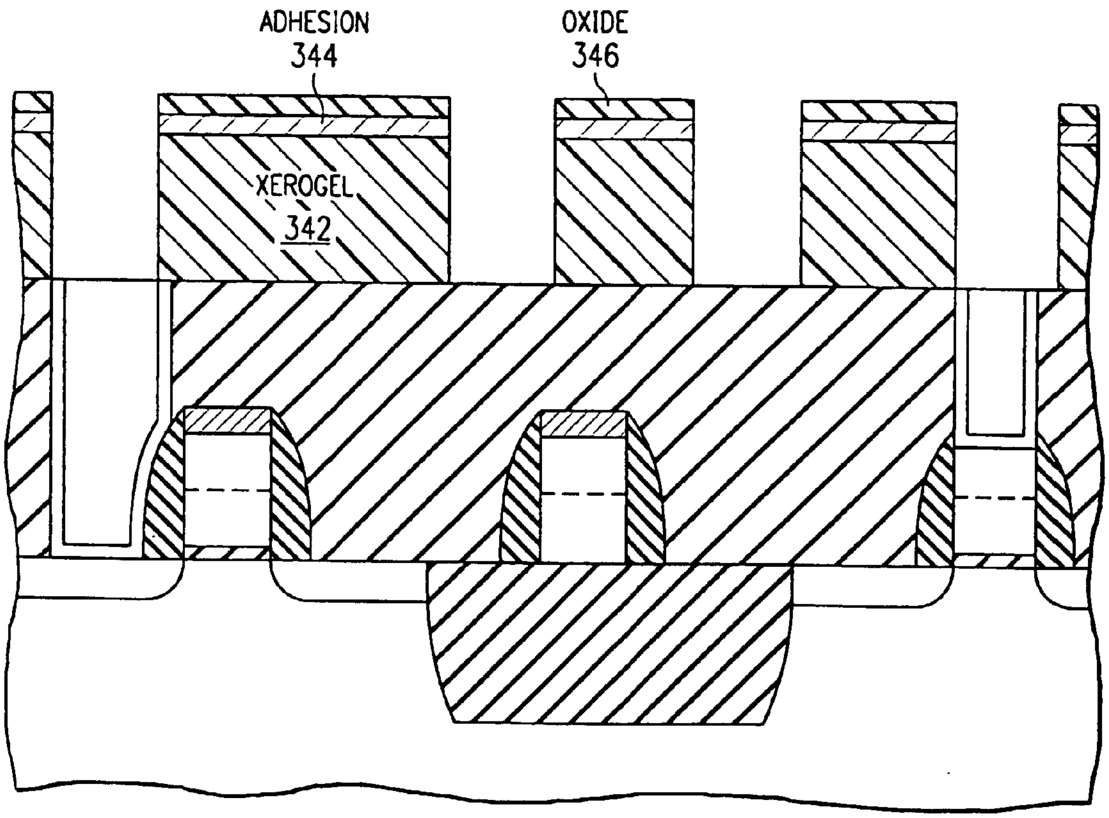


*FIG. 3e*

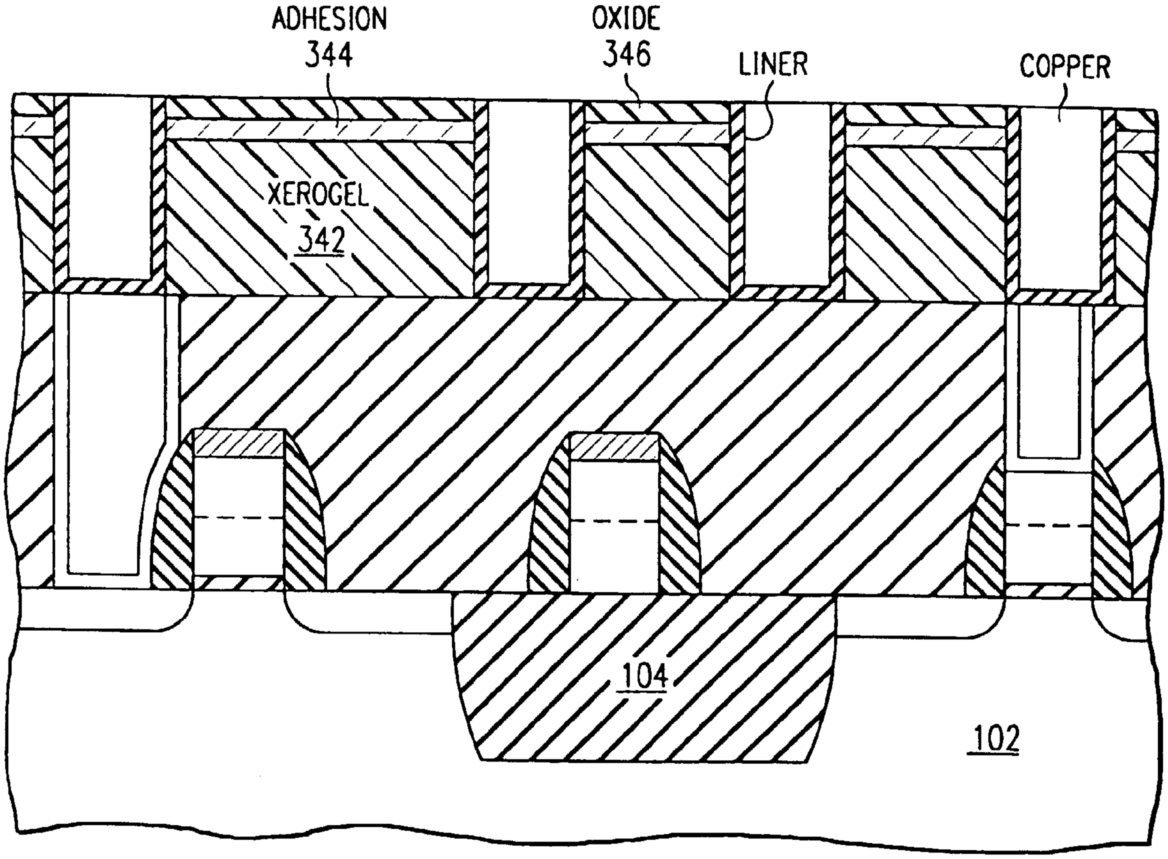
ADHESION
344
OXIDE
346
LINER
COPPER
XEROGEL
342
104
102

*FIG. 3f*

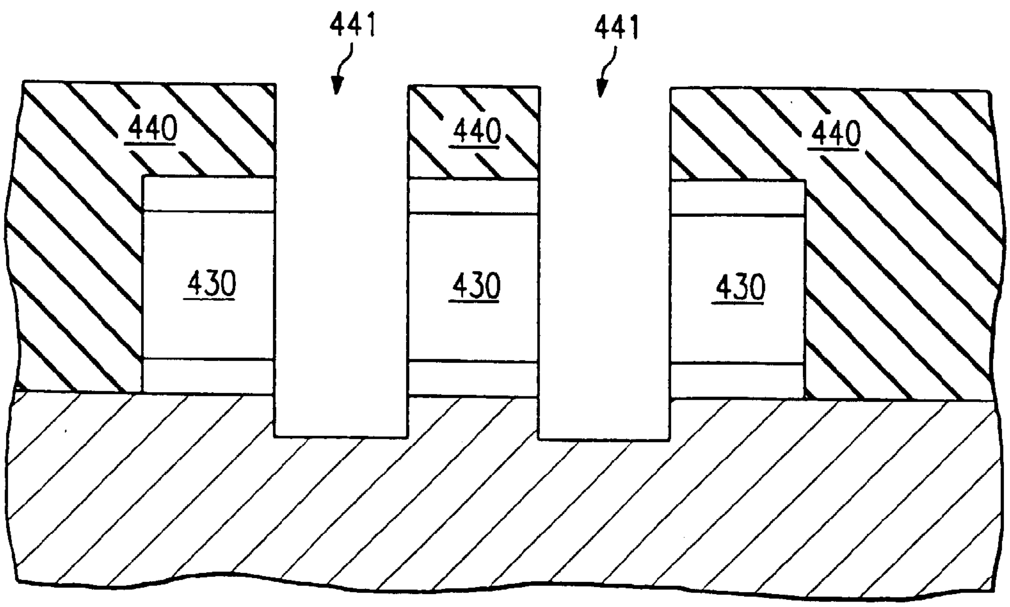
441
441
440
440
440
430
430
430

*FIG. 4a*

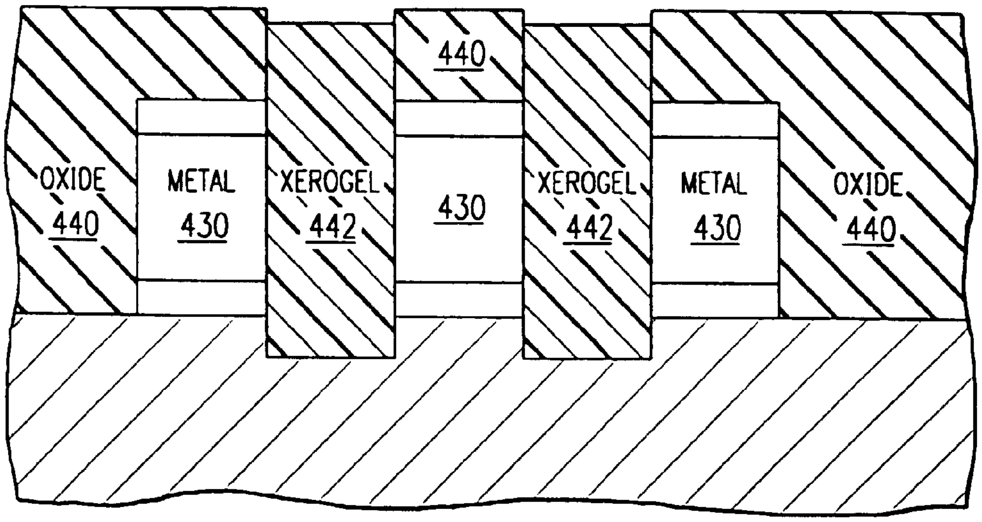
440
OXIDE
440
METAL
430
XEROGEL
442
430
XEROGEL
442
METAL
430
OXIDE
440

FIG. 4b

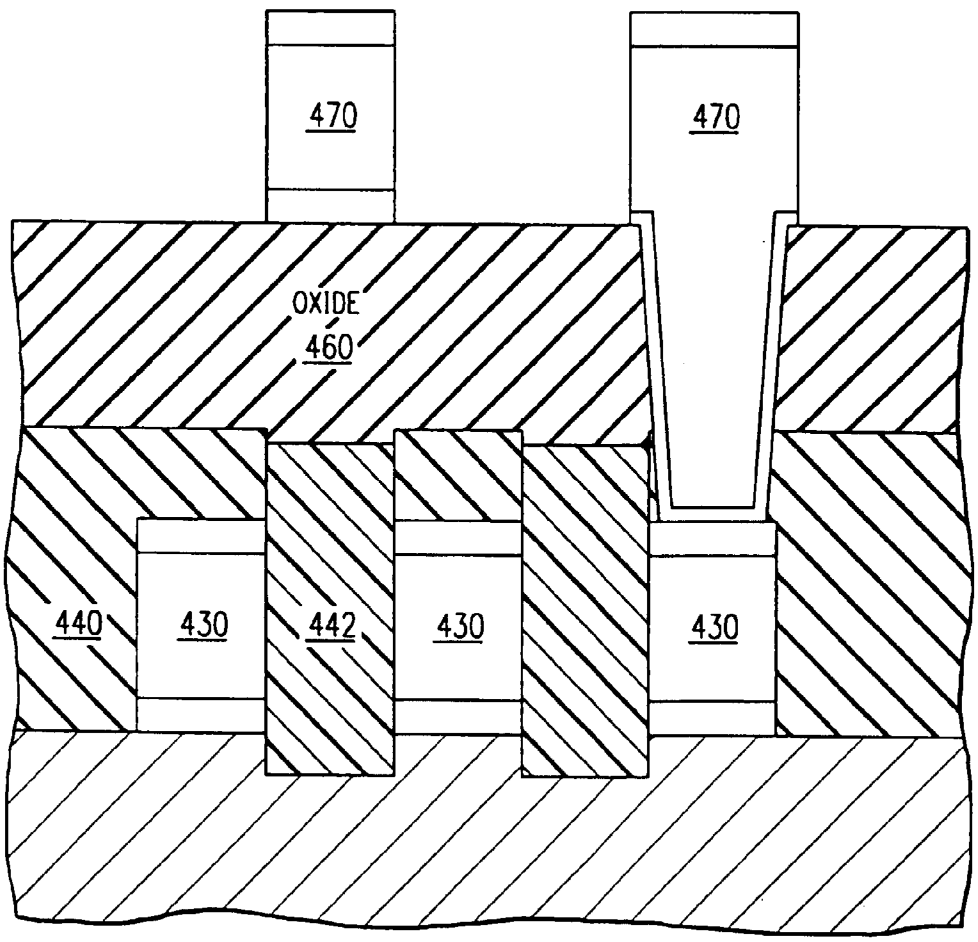
470
470
OXIDE
460
440
430
442
430
430

FIG. 4c

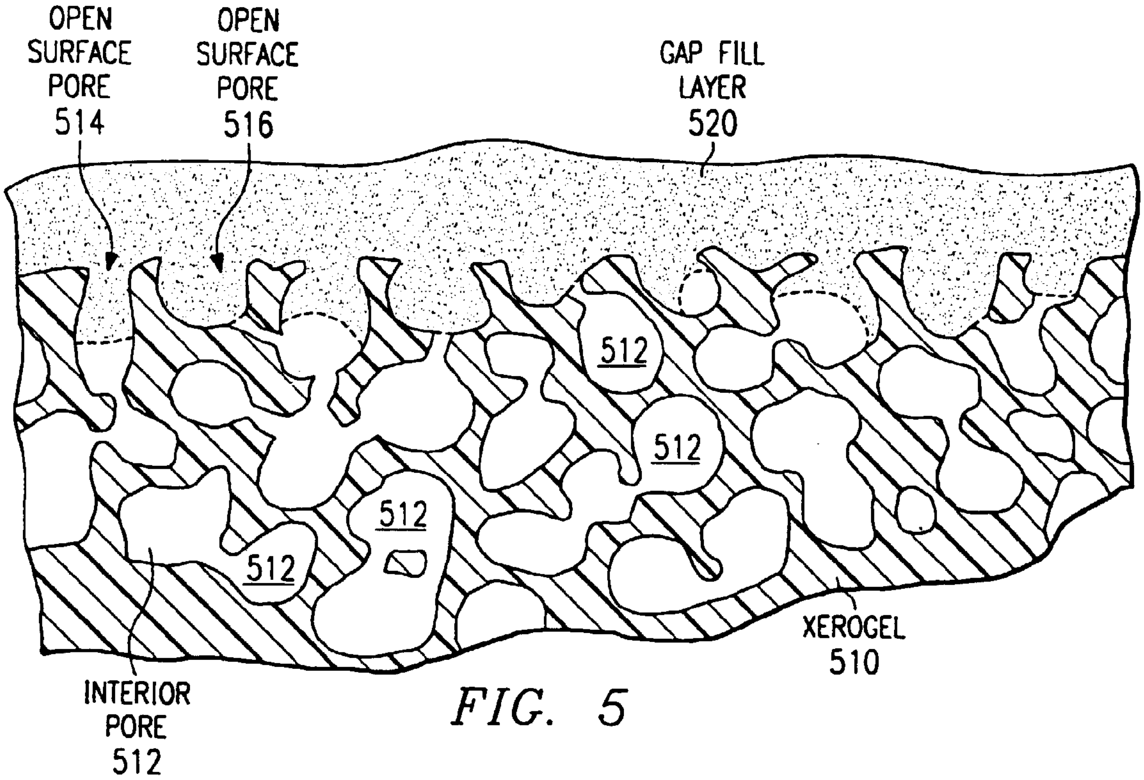
OPEN
SURFACE
PORE
514
OPEN
SURFACE
PORE
516
GAP FILL
LAYER
520
512
512
512
512
XEROGEL
510
INTERIOR
PORE
512

*FIG. 5*

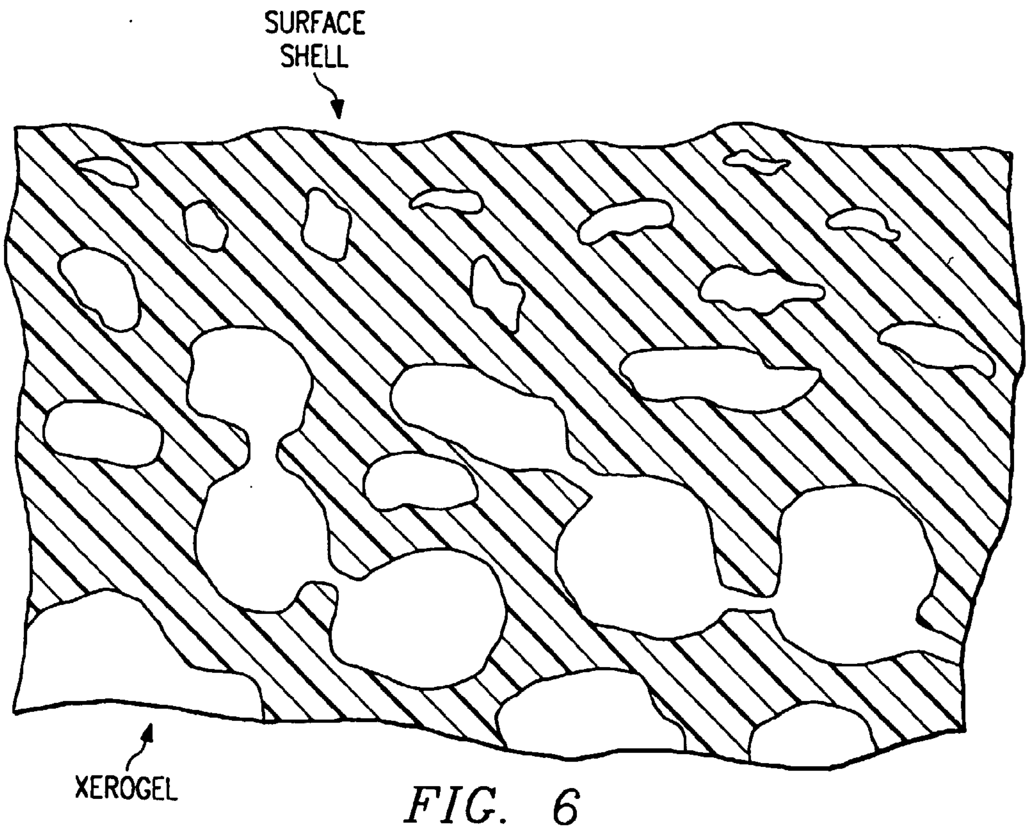
SURFACE
SHELL
XEROGEL

*FIG. 6*

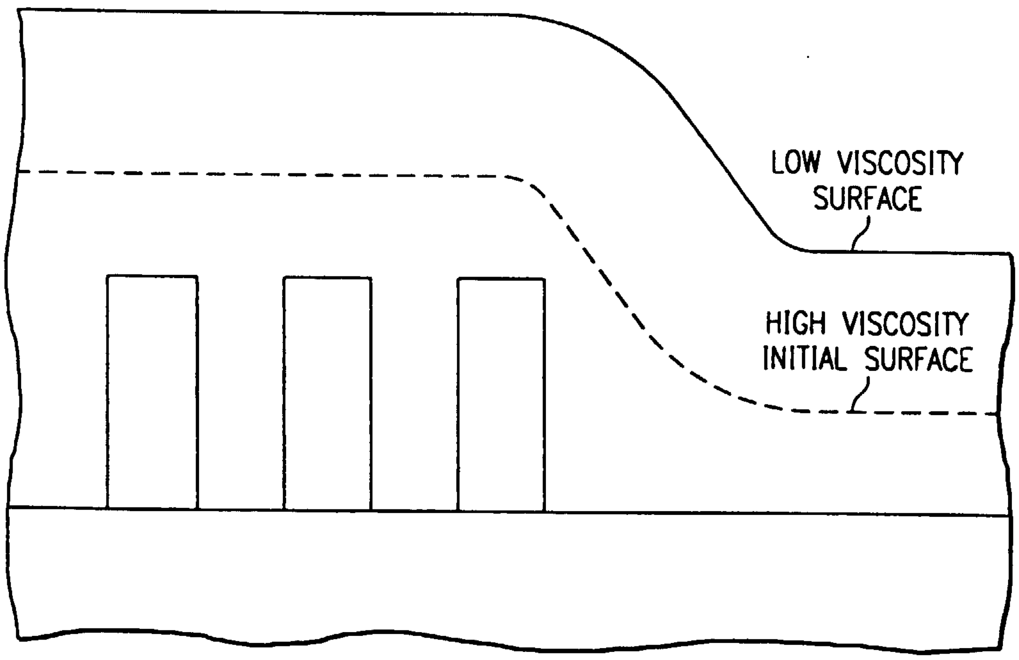
LOW VISCOSITY
SURFACE
HIGH VISCOSITY
INITIAL SURFACE

*FIG. 7a*

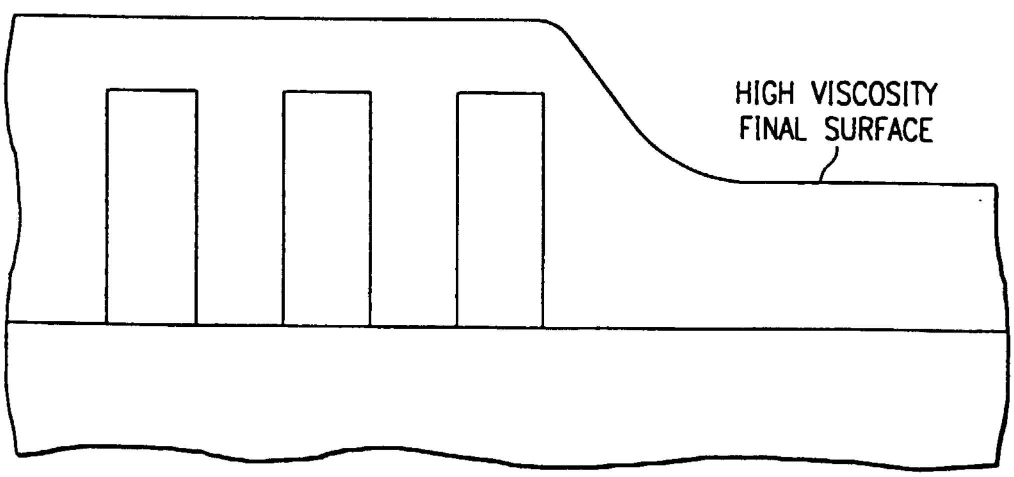
HIGH VISCOSITY
FINAL SURFACE

*FIG. 7b*

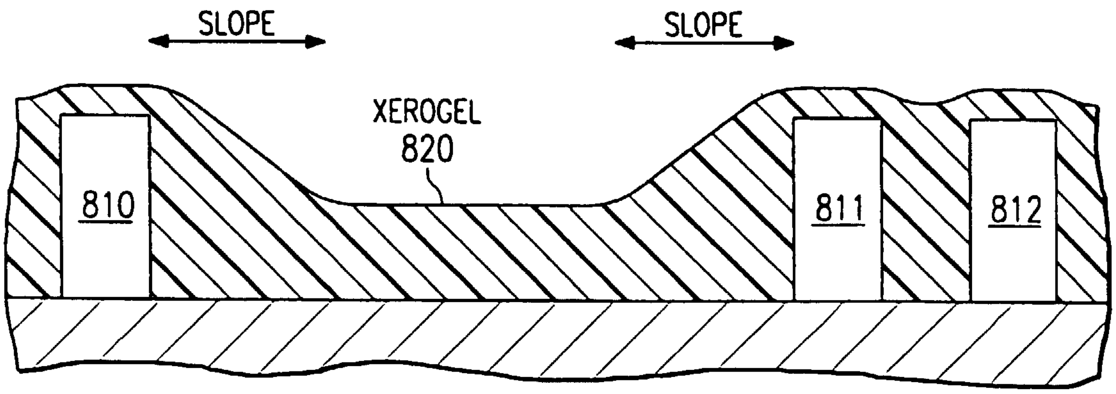
SLOPE
SLOPE
XEROGEL
820
810
811
812

*FIG. 8a*

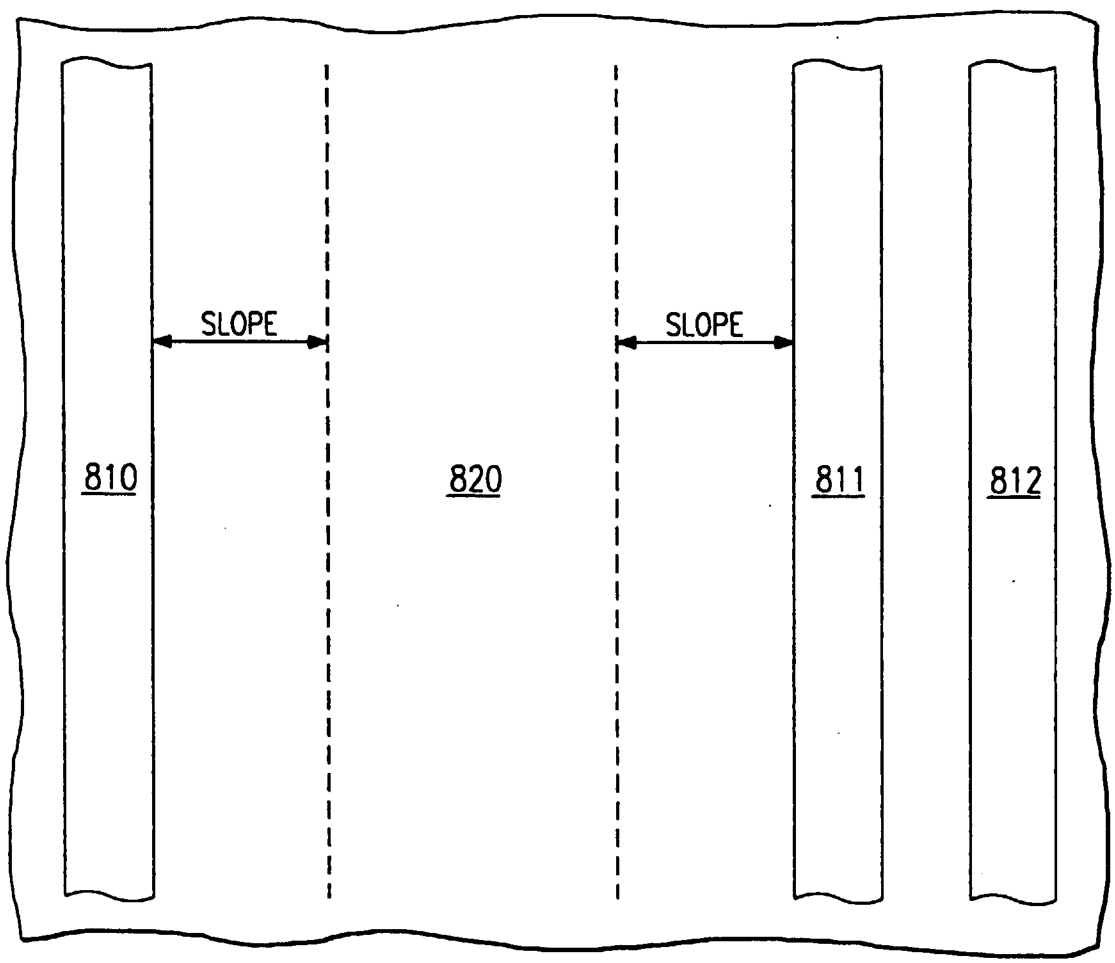
SLOPE
SLOPE
810
820
811
812

*FIG. 8b*

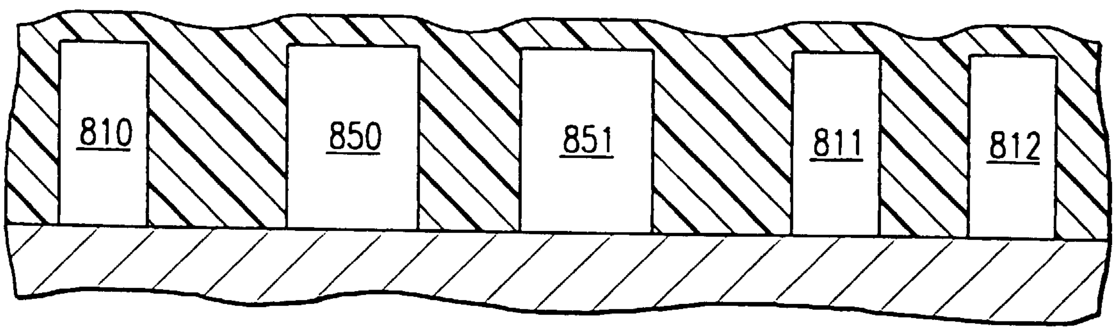


FIG. 8c

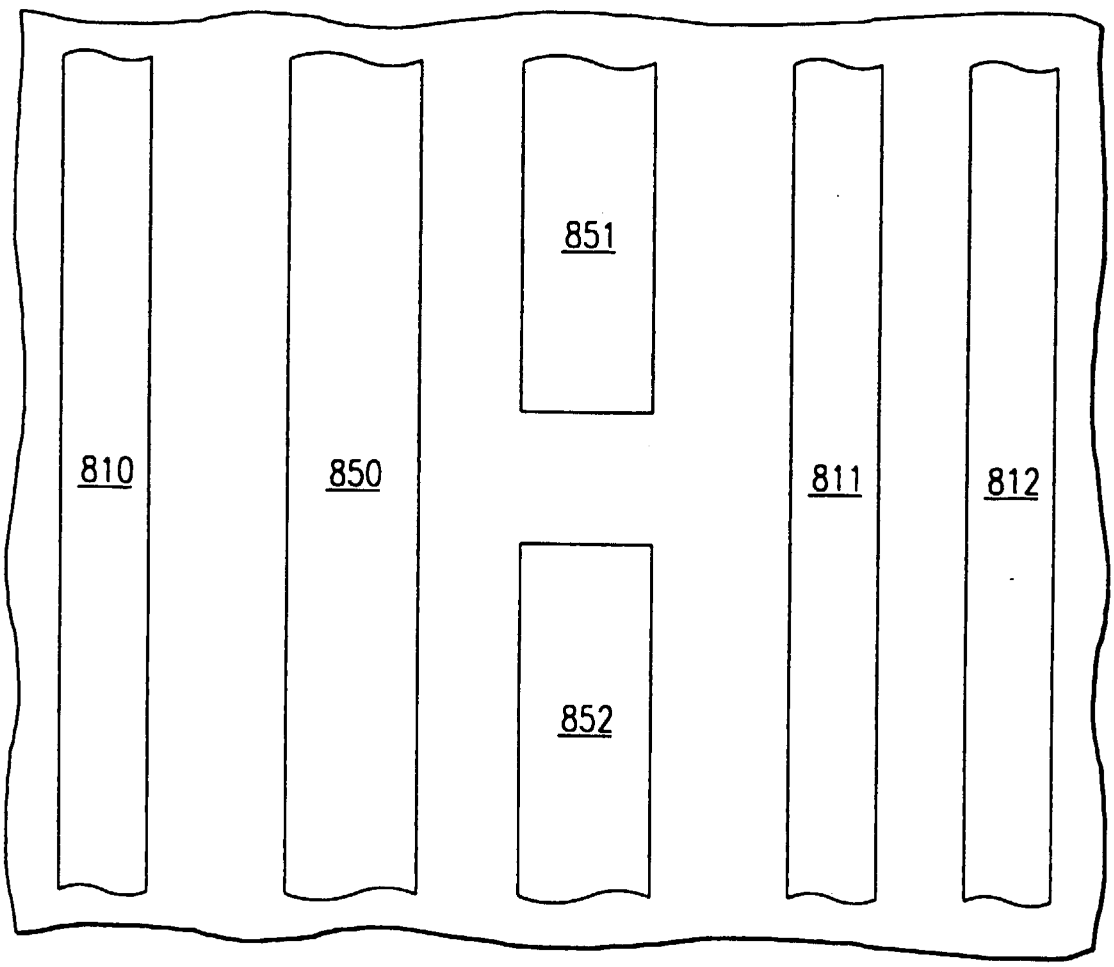


FIG. 8d

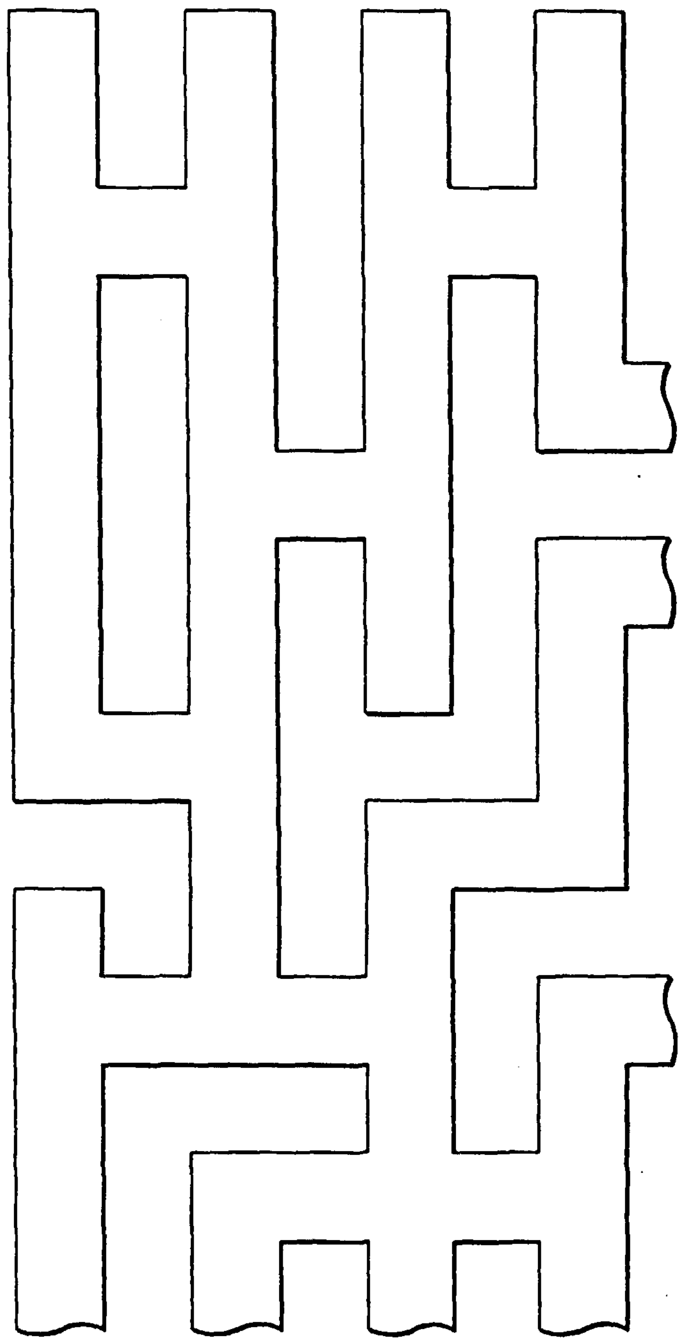

FIG. 8e